# EUROPEAN PATENT APPLICATION

(11) **EP 3 736 407 A1**
(43) Date of publication of application: **11.11.2020**
(21) Application number: 19213172.0
(22) Date of filing: 03.12.2019
(51) Int. Cl.: F01C 21/00, F01C 21/10, F04C 23/00, F04C 29/00, F04C 18/02

(54) **ELECTRIC COMPRESSOR**

(30) Priority: 09.05.2019 KR 20190054483
(71) Applicant: LG Electronics Inc., SEOUL, 07336 (KR)
(72) Inventor: YIM, Namsik, 08592 Seoul (KR); KIM, Taekyoung, 08592 Seoul (KR); CHO, Yongsoo, 08592 Seoul (KR); CHOI, Soonyong, 08592 Seoul (KR)
(74) Representative: Ter Meer Steinmeister & Partner

(57) **Abstract**

Disclosed is an electric compressor. An electric compressor according to an embodiment of the present disclosure includes an electrically conductive part for electrically conductively connecting an inverter and a motor part. The motor part is detachably inserted through and coupled to the inverter and the motor part. Accordingly, the inverter and the electrically conductive part may be electrically conductive to each other by a simple structure. The electrically conducive part includes an elastic member. The elastic member is configured to cancel vibration generated along with the operation of the motor part. When the motor part is vibrated and moved, the elastic member is compressed or stretched to prevent the vibration of the motor part from being transferred to the inverter. Thus, it is possible to prevent the inverter from being damaged due to the vibration of the motor part. The electrically conductive part is brought into direct contact with a printed circuit board in the inverter. Accordingly, a busbar assembly for electrically conductively connecting the printed circuit board and the electrically conductive part is not required. As a result, there is no need for a space for housing the busbar assembly in the inverter, and thus it is possible to miniaturize the inverter and further the electric compressor.

## Description

### BACKGROUND OF THE INVENTION

### 1. Field of the Invention

The present disclosure relates to an electric compressor, and more particularly, to an electric compressor having a motor part driven by electric current for generating a rotational force for compressing refrigerant, an inverter that applies power to drive the motor part and an electric connection structure between the motor part and the inverter.

### 2. Background of the Invention

Compressors serving to compress refrigerant in air conditioning systems for vehicle have been developed in various forms. In recent years, electric compressors (motor-operated compressors) driven by electric power using motors have been actively developed according to the tendency of electrification of vehicle components.

A motor-operated compressor generally employs a scroll-compression method which is suitable for a high compression ratio operation. Such a scroll-type motor-operated compressor (hereinafter, referred to as "motor-operated compressor") includes a motor part, a compression part, and a rotating shaft connecting the motor part and the compression part.

Specifically, the motor part is configured as a rotary motor or the like, and installed inside a hermetic casing. The compression part is located at one side of the motor part, and is provided with a fixed scroll and an orbiting scroll. The rotating shaft is configured to transmit rotational force of the motor part to the compression part.

The refrigerant compressed in the compression part is exhausted to outside of the electric compressor through an exhaust port. The exhausted refrigerant is utilized for operating an air conditioning system for vehicle.

An electric part includes a stator and a rotor. A plurality of coils are wound around the stator. Also, a magnet is provided in the rotor. The magnet provided in the rotor is generally a permanent magnet.

When power is applied to the electric part, a magnetic field is formed by the plurality of coils wound around the stator. The formed magnetic field exerts electromagnetic force on the magnet provided in the rotor. Thus, the rotor having the magnet is rotated according to the strength and direction of the electromagnetic force.

Power and a control signal for driving the electric part are applied by an inverter device. The inverter device is housed in an inverter and is electrically conductively connected to a motor part through a busbar.

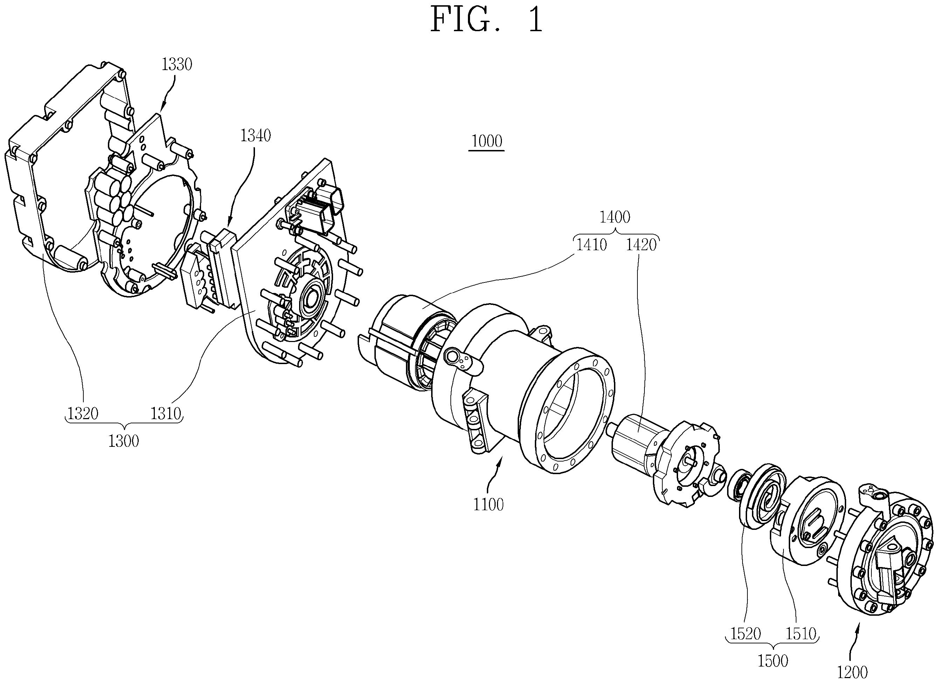

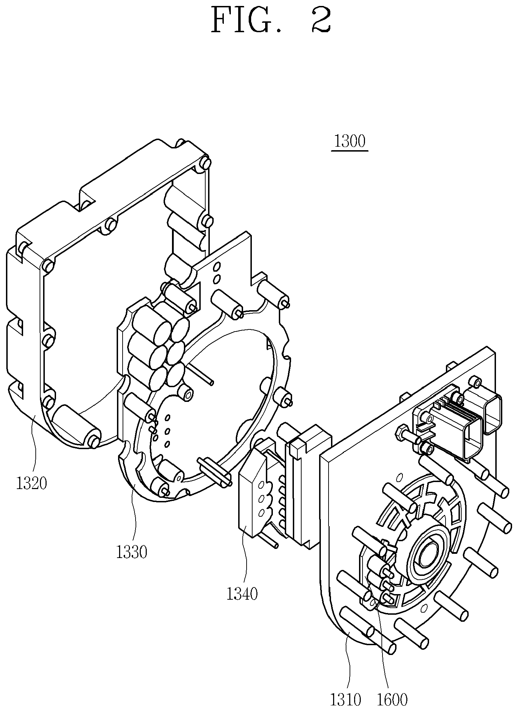

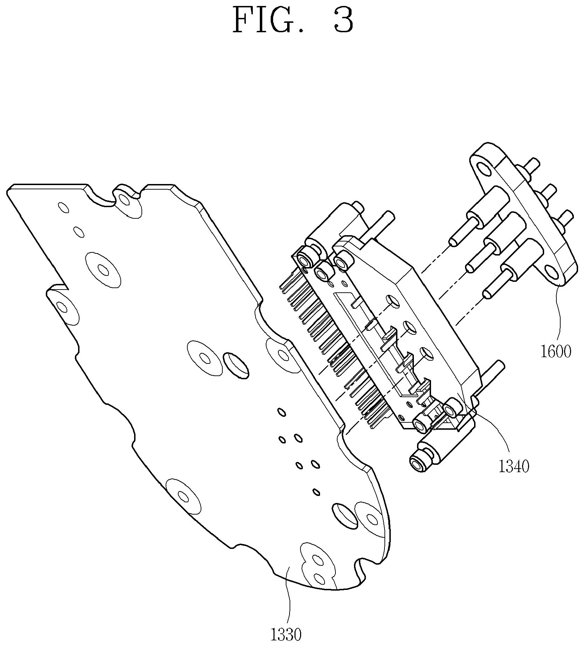

Referring to FIGS. 1 to 3, an electric compressor 1000 according to a related art is shown. An inverter element 1330 and a busbar assembly 1340 electrically conductively connected to the inverter element 1330 are provided inside an inverter housing 1300 of the electric compressor 1000.

The electric compressor 1000 according to the related art is configured such that a connector 1600 should be electrically conductive to an electric part 1400 via a busbar assembly 1340. This is due to the absence of a separate member for connecting the inverter element 1330 to the connector 1600.

That is, as shown, a plurality holes to be connected to the connector 1600 are formed in the busbar assembly 1340 while no separate holes are formed in the inverter element 1330. In the inverter element 1330, holes into which a plurality of pins provided in the busbar assembly are to be inserted are just present.

Therefore, the busbar assembly 1340 must be provided in order for the inverter element 1330 to be electrically conductive to the electric part 1400.

However, the busbar assembly 1340 includes several electrically conductive members for electrically provide polyphase current applied to the inverter element 1330. Accordingly, the busbar assembly 1340 should typically be manufactured with a large volume, thereby increasing the size of the inverter housing 1300. As a result, the overall size of the electric compressor 1000 is increased.

On the other hand, as the size of the electric compressor 1000 decreases, the electric compressor 1000 is more easily provided in a vehicle or the like. Accordingly, in order to minimize of the increase in size due to the busbar assembly 1340, an internal structure of the inverter housing 1300 is very densely formed. This causes complexity of a process of manufacturing the electric compressor 1000.

Also, it is difficult for the busbar assembly 1340 to be fully coupled to the inverter element 1330 by a method such as soldering because of structural limitations. Accordingly, it is difficult to stably maintain the electrically conductive state between the busbar assembly 1340 and the inverter element 1330, and thus a poor contact or the like may be generated.

Furthermore, when vibration is generated due to rotation of the electric part 1400, the inverter element 1330 sensitive to shock and the busbar assembly 1340 connected to the inverter element 1330 may be damaged.

However, the electric compressor 1000 according to related art has no member for preventing the generated vibration from being transferred to the inverter housing 1300 because of the narrow inner space of the inverter housing 1300. Accordingly, it is difficult to prevent the inverter element 1330 from being damage due to the continuous operation of the electric compressor 1000.

Korean Patent No. 10-0763161 discloses a vibration reduction structure of a hermetic compressor having a corrugated pipe portion for absorbing vibration. In detail, the patent document discloses a vibration reduction structure capable of forming a portion of a pipe for connecting an accumulator and a sealed container as a corrugated pipe and thus preventing vibration generated by pressure pulsation from being transferred to the accumulator.

However, this type of vibration reduction structure can prevent the transfer of vibration between the accumulator and the sealed container, but there is a limitation in that there is no consideration about a structure for reducing vibration of an inverter housing in which the inverter element is to be housed.

Korean Patent No. 10-0867623 discloses a vibration reduction device of a compressor. In detail, the parent document discloses a vibration reduction device including a vibration absorption unit for absorbing rotational direction vibration generated when a driving motor is operated.

However, this type of vibration reduction device is for reducing rotational direction vibration, and there is a limitation in that there is no consideration about how to prevent vibration from being transferred to an inverter housing in which an inverter element is to be housed along an axial direction.

Furthermore, the above-mentioned related documents further include a limitation in that there is no consideration about an electric compressor having a structure that can easily implement electric conduction between an electric part and an inverter device.

### [Related Art Documents]

### [Patent Documents]

Korean Patent No. 10-0763161 (October 5, 2007)
Korean Patent No. 10-0867623 (November 10, 2008)

### SUMMARY OF THE INVENTION

The present disclosure is directed to providing an electric compressor having a structure capable of solving the above problems.

First, the present disclosure is directed to providing an electric compressor, i.e. a compressor driven by an electric motor, having a structure capable of simplifying an electrically conductive structure between an inverter and an electric part e.g. the electric motor.

Also, the present disclosure is directed to providing an electric compressor having a structure capable of preventing vibration generated when an electric part is operated from being transferred to an inverter device.

Also, the present disclosure is directed to providing an electric compressor having a structure capable of stably maintaining an electrically conductive state between an inverter and an electric part.

Also, the present disclosure is directed to providing an electric compressor having a structure capable of reducing the size of the electric compressor.

Also, the present disclosure is directed to providing an electric compressor having a structure capable of easily implementing a producing process.

Also, the present disclosure is directed to providing an electric compressor having a structure capable of simplifying an internal structure of an inverter housing in which an inverter is to be housed.

The above objectives are achieved by the subject-matter of the independent claim.

There is provided an electric compressor, i.e. a compressor wherein compression is achieved by an electrically driven motor as opposed to conventionally known belt-driven compressors. The electrical compressor i.e. the compressor of the present technique includes a motor part. The motor part may include a stator and a rotor rotatably housed in the stator. The compressor of the present technique, hereinafter referred to as the compressor or the electric compressor, may include an inverter electrically conductively, i.e. electrically, connected to the motor part to apply a control signal to the motor part. The compressor may further include a compression part connected to the motor part. The compression part may be configured to compress refrigerant. The compression part may be configured to rotate along with rotation of the motor part to compress refrigerant. The compressor may further include an electrically conductive part configured to electrically conductively, i.e. electrically, connect the motor part and the inverter. The electrically conductive part may include one or more of a support member forming a body; a terminal member formed to extend lengthwise, inserted through and coupled to the support member, and electrically conductively connected to the inverter; and an elastic member provided between the support member and the terminal member facing the inverter and compressed and/or stretched by vibration generated in the motor part to store a restoring force.

The terminal member of the electric compressor may include an input terminal located in a direction facing the inverter and an output terminal located in a direction opposite to the input terminal and facing the motor part. The input terminal may be electrically conductively connected to the inverter and the output terminal may be electrically conductively connected to the motor part.

The input terminal and the output terminal of the electric compressor may be electrically conductively connected to each other.

The electrically conductive part of the electric compressor may include a connection member inserted through and coupled to the support member. The connection member may be configured to surround a part of the terminal member adjacent to the support member.

The elastic member of the electric compressor may be provided as a coil spring having a hollow portion formed therein. The terminal member may be inserted through and coupled to the hollow portion.

The inverter of the electric compressor may include an inverter housing forming an external appearance on one side facing the motor part. The inverter may include an inverter cover located on the other side of the inverter housing opposite to the motor part, coupled to the inverter housing, and configured to form an inverter chamber therein. The inverter may include a printed circuit board housed in the inverter chamber.

The inverter of the compressor may include an input terminal housing part. Optionally and more specifically, the printed circuit board of the electric compressor may include the input terminal housing part. Optionally, the input terminal housing part may be formed through the printed circuit board. The input terminal housing part may be configured such that the input terminal is inserted to the input terminal housing part. The inverter of the compressor may include an input terminal connection part. Optionally and more specifically, the printed circuit board of the electric compressor may include the input terminal connection part. The input terminal connection part may be provided in the input terminal housing part and may be brought in electrically conductive contact with the input terminal.

The inverter housing of the electric compressor may include a support member insertion hole. The support member insertion hole may be recessed a predetermined distance from one surface facing the motor part. The support member insertion hole may be configured such that the support member is inserted to the support member insertion hole.

The inverter housing of the electric compressor may include an input terminal insertion hole. The input terminal insertion hole may be formed through one surface facing the motor part. The input terminal insertion hole may be configured such that the input terminal is inserted through and coupled to the input terminal insertion hole.

When the electrically conductive part and the inverter of the electric compressor are coupled to each other, the input terminal may be inserted through and coupled to the input terminal insertion hole and may be inserted into and coupled to the input terminal housing part such that the input terminal is in electrically conductive contact with the input terminal connection part.

The motor part of the electric compressor may include an output terminal housing part located on the one side of the motor part facing the inverter and configured such that the motor part is inserted into, coupled to, and electrically conductively connected to the output terminal.

The elastic member of the electric compressor may be formed of two or more different materials along a length direction thereof.

Optionally, one side of the electric compressor in the length direction of the elastic member adjacent to the support member may be formed of a copper-nickel (Cu-Ni) alloy material. The other side opposite to the one side in the length direction of the elastic member maybe formed of an iron-nickel (Fe-Ni) alloy material.

The terminal member of the electric compressor may be formed of an iron-nickel alloy material.

The terminal member of the electric compressor may be formed of a ceramic material.

According to an aspect of the present technique a compressor having a compression part, a motor part, an inverter and an electrically conductive part is provided. The compression part is for compressing refrigerant. The motor part may drive the compression part. The motor part may be an electrical motor. The inverter may be electrically connected to the motor part for applying a control signal to the motor part. The electrically conductive part may electrically connect the motor part and the inverter.

The electrically conductive part may include a terminal member and an elastic member. A support member, as previously described, may be optionally included. The terminal member may be formed in an elongated shape. The terminal member may have an input terminal and an output terminal, preferably at the two ends, separated in lengthwise direction, of the elongated shaped body of the terminal member, for e.g. a rod shape or a bar shape, etc. The input terminal may electrically connect to the inverter, for example via an input terminal housing part of the inverter, i.e. the input terminal may be physically connected to the input terminal housing part of the inverter thereby establishing electrical connection between the input terminal and the input terminal housing part and consequently between the input terminal and the inverter. The output terminal may electrically connect to the motor part, for example via an output terminal housing part of the motor part, i.e. the output terminal may be physically connected to the output terminal housing part of the motor part thereby establishing electrical connection between the output terminal and the output terminal housing part and consequently between the output terminal and the motor part.

The elastic member may be provided between the inverter and the motor part. The elastic member may be attached or unattached, i.e. fixed or free, at its opposite ends to the inverter and the motor part. The elastic member may provide a restoring force when being compressed by vibration of the motor part. In other words, when the vibration force of the motor part tends to relatively move the motor part and the inverter towards each other, then the elastic member which is placed in-between the motor part and the inverter is compressed or pressed or contracted and consequently absorbs the movement due to vibration and may provide the restoring force to the motor part and the inverter or may resist the relative movement of the motor part and the inverter due to the restoring force.

The input terminal may be slidably connected to the inverter and/or the output terminal may be slidably connected to the motor part, while maintaining the electrical connection between the motor part and the inverter. In other words, the input terminal may slide, for example in a to-and-fro direction, within the input terminal housing part, and thereby even though the physical position of the input terminal within the input terminal housing part changes, due to the relative sliding of the input terminal housing part and the input terminal which may be caused as a result of the vibration of the motor part, the electrical connection between the input terminal and the input terminal housing part is maintained during the sliding, and consequently the electrical connection between the input terminal and the inverter is maintained, and further consequently the electrical connection between the inverter and the motor part is maintained. The input terminal may be, but not limited to, bar shaped or pin shaped or rod shaped, and the input terminal housing part may be a receptacle-shaped with a corresponding shape to receive the input terminal. The input terminal and the correspondingly shaped input terminal housing part may be longitudinally or axially aligned i.e. aligned along their respective longitudinal axis when input terminal is inserted into the input terminal housing part. The to-and-fro direction may be axial direction or longitudinal direction. When the elastic member is in its default shape the input terminal may be positioned such that the input terminal only occupies substantially half, in longitudinal direction, of the input terminal housing part, thus there is space for the input terminal to slide, for example in the to-and-fro direction, within the input terminal housing part without getting expelled from the input terminal housing part or without being restricted by the longitudinal extent of the input terminal housing part.

Additionally or alternatively, the output terminal may slide, for exmaple in a to-and-fro direction, within the output terminal housing part, and thereby even though the physical position of the output terminal within the output terminal housing part changes, due to the relative sliding of the output terminal housing part and the output terminal which may be caused as a result of the vibration of the motor part, the electrical connection between the output terminal and the output terminal housing part is maintained during the sliding, and consequently the electrical connection between the output terminal and the motor part is maintained, and further consequently the electrical connection between the inverter and the motor part is maintained. The output terminal may be, but not limited to, bar shaped or pin shaped or rod shaped, and the output terminal housing part may be a receptacle-shaped with a corresponding shape to receive the output terminal. The output terminal and the correspondingly shaped output terminal housing part may be longitudinally or axially aligned i.e. aligned along their respective longitudinal axis when the output terminal is inserted into the output terminal housing part. The to-and-fro direction may be axial direction or longitudinal direction. When the elastic member is in its default shape the output terminal may be positioned such that the output terminal only occupies substantially half, in longitudinal direction, of the output terminal housing part, thus there is space for the output terminal to slide in the to-and-fro direction within the output terminal housing part without getting expelled from the output terminal housing part or without being restricted by the longitudinal extent of the output terminal housing part.

In short, when due to vibration of the motor part, or due to any other sources of vibration, the motor part and the inverter relatively move towards each other from a default separation (a separation distance that exists between the motor part and the inverter when the motor part is not being operated or is not vibrating), the elastic member disposed thereinbetween gets compressed by being physically pressed, directly or indirectly, by the motor part and/or the inverter. As a result of this compression of the elastic member, a restoring force is generated in the elastic member. The restoring force counteracts the relative movement of the motor part and the inverter, and tends to or partially or completely reverses the relative movement of the motor part and the inverter to push them to the default separation. During the above described relative movement of the inverter and the motor part towards each other, for example as a result of motor part vibration, and thereafter the above described relative movement of the inverter and the motor part away from each other, resulting from the restoring force of the elastic member, physical detachment and consequent disconnection of the terminal member from the motor part and/or the inverter is avoided because the input terminal is slidably connected to the inverter and/or the output terminal is slidably connected to the motor part. Thus the input terminal and/or the output terminal slide, i.e. maintain physical contact while relatively moving, and consequently maintain the electrical connection between the motor part and the inverter while sliding, as well as when coming to rest after the sliding ceases.

Similarly, when due to vibration of the motor part, or due to any other sources of vibration, the motor part and the inverter relatively move away from each other from the default separation, the elastic member disposed thereinbetween gets stretched by being physically pulled, directly or indirectly, by the motor part and/or the inverter. As a result of this stretching of the elastic member, a restoring force is generated in the elastic member. The restoring force counteracts the relative movement of the motor part and the inverter, and tends to or partially or completely reverses the relative movement of the motor part and the inverter to pull them back to the default separation. During the above described relative movement of the inverter and the motor part away from each other, for example as a result of motor part vibration, and thereafter the above described relative movement of the inverter and the motor part towards each other, resulting from the restoring force of the elastic member, physical detachment and consequent disconnection of the terminal member from the motor part and/or the inverter is avoided because the input terminal is slidably connected to the inverter and/or the output terminal is slidably connected to the motor part. Thus the input terminal and/or the output terminal slide, i.e. maintain physical contact while relatively moving, and consequently maintain the electrical connection between the motor part and the inverter while sliding, as well as when coming to rest after the sliding ceases.

The distance the elastic member is compressed or stretched corresponds to the distance the input and/or the output terminal slide.

The input terminal may be electrically connected to the inverter by being received into the input terminal housing part of the inverter i.e. the input terminal may be inserted into the input terminal housing part. The input terminal and the input terminal housing part may be shaped such that the input terminal friction fits into the input terminal housing part, however a tightness of the fit may be such that relative sliding of the input terminal and the input terminal housing part is not hindered or prohibited. Similarly, the output terminal may be electrically connected to the motor part by being received into the output terminal housing part of the motor part i.e. the output terminal may be inserted into the output terminal housing part. The output terminal and the output terminal housing part may be shaped such that the output terminal friction fits into the output terminal housing part, however a tightness of the fit may be such that relative sliding of the output terminal and the output terminal housing part is not hindered or prohibited.

A space, for receiving the input terminal, of the input terminal housing part may be such that to accommodate a sliding movement of the input terminal. A space, for receiving the output terminal, of the output terminal housing part may be such that to accommodate a sliding movement of the output terminal. The sliding movement of the input terminal and/or the output terminal may correspond to a compression of the elastic member due to vibration of the motor part.

The terminal member may passes through the elastic member.

The elastic member may have an elongated shape.

The elastic member may comprise at least two parts sequentially arranged along a length direction thereof. The at least two parts may be formed of at least two different materials.

The inverter may include a printed circuit board (PCB). The PCB may include the input terminal housing part. The input terminal housing part may be formed through the PCB, for example through a substrate of the PCB, such as a through-hole in the substrate of the PCB. The input terminal housing part may receive the input terminal. An input terminal connection part may be provided at the input terminal housing part, for example at least a part of the input terminal connection part may be provided within the input terminal housing part. The input terminal connection part electrically contacts the input terminal to electrically connect the terminal member to the printed circuit board when the input terminal is received into the input terminal housing part.

The inverter may include an inverter housing forming an external appearance of the inverter on a side of the inverter facing the motor part. Optionally, the inverter may include an inverter cover located on the other side of the inverter housing opposite to the motor part. The inverter cover may be coupled to the inverter housing to form an inverter chamber therein. The PCB may be housed in the inverter chamber.

The electrically conductive part may further include a support member through which one or more of the terminal members pass through, optionally slidably. The inverter housing may include a support member insertion hole, which may be formed as a recess or a blind-hole, facing the motor part. The support member insertion hole may receive the support member. For example the support member may be fixed onto the motor part opposite to the support member insertion hole of the inverter housing, and thus when the inverter and the motor part move towards each other, due to vibrations of the motor part, the support part may move into the support member insertion hole, without impacting the inverter housing. Subsequently, when the motor part and the inverter move away from each other due to restoring force of the elastic member, the support member may move out of the support member insertion hole.

The inverter housing may include an input terminal insertion hole formed in the support member insertion hole. The input terminal may be inserted through, and optionally coupled to, the input terminal insertion hole.

The input terminal inserted through, and optionally coupled to, the input terminal insertion hole may be inserted in, and optionally coupled to, the input terminal housing part such that the input terminal is in physical, and thus electrical, contact with the input terminal connection part.

The electrically conductive part may include the support member through which the terminal member or members slidably pass. The support member may be fixed to the motor part.

The elastic member may be fixed at its one end to the motor part and at its other end to the inverter, directly or indirectly, for providing a restoring force when being stretched. For example, the elastic member may be fixed at its one end to the support member and at the other end to the other one of the inverter and the motor part, for providing a restoring force when being stretched.

The elastic member may have an elongated shape. The elastic member may comprise at least two parts sequentially arranged along a length direction thereof. The at least two parts may include a part, say a first part, arranged adjacent to the support member, i.e. in and around the support member. The first part may be formed at one end of the elongated elastic member. The first part may be formed of a copper-nickel (Cu-Ni) alloy material. The at least two parts may further include a part, say a second part, at another end of the elongated elastic member opposite to the one end or the first part. The second part may be formed of an iron-nickel (Fe-Ni) alloy material.

The electrically conductive part may include a connection member. The connection member may be inserted through, and optionally coupled to, the support member. The connection member may be configured to surround a part of the terminal member adjacent to the support member, i.e. the connection member through which the terminal member is inserted, is inserted through the support member and protrudes out on both sides of the support member. The connection member may be formed of an electrically insulating material, preferably of ceramic material.

The terminal member may be formed of an iron-nickel alloy material.

The elastic member may be, but not limited to, one of a spring element, a leaf spring, and a coil spring.
The output terminal housing part of the motor part is located at a side of the motor part facing the inverter. The output terminal housing part may be located at the stator of the motor part. The output terminal housing part may electrically connect the motor part to the inverter when the output terminal is received into the output terminal housing part.

### ADVANTAGEOUS EFFECTS OF THE INVENTION

According to the present disclosure, the following effects can be achieved.

First, an inverter and a motor part are connected to each other by an electrically conductive part. The electrically conductive part is inserted into and coupled to an output terminal housing part of the motor part and thus is electrically conductively connected to the motor part. Also, the electrically conductive part is inserted into and coupled to an input terminal housing part of the inverter and is electrically conductively connected to an input terminal connection part.

Accordingly, the inverter and the motor part may be electrically conductive to each other only by inserting and coupling the electrically conductive part into and to the inverter and the motor part. As a result, a complicated wiring structure for electrical conduction between the inverter and the motor part is not required.

Also, an elastic motor is provided on one side of the electrically conductive part facing the inverter. The elastic member is compressed or stretched by vibration generated when the motor part is operated.

Accordingly, although the vibration is generated due to the operation of the motor part, the generated vibration is damped by the elastic member. As a result, the vibration generated by the motor part may not be transferred to the inverter.

Also, the electrically conductive part is inserted into and coupled to the motor part and the inverter. Accordingly, a wiring structure for electrically conductively connecting the electrically conductive part to the motor part and the inverter is not required.

Accordingly, a separate fastening member for maintaining a state in which the wiring is connected to the motor part and the inverter is not required. Furthermore, a terminal member of the electrically conductive part may be coupled to the input terminal connection part of the inverter by a method such as soldering. As a result, the electrically conductive state between the inverter, the electrically conductive part, and the motor part may be stably maintained.

Furthermore, there is no need for a process for connecting and fastening the wiring to inverter and the motor part. Accordingly, it is possible to simplify a process of producing the electric compressor.

Also, the input terminal of the electrically conductive part is brought into direct contact with a printed circuit board of the inverter.

Accordingly, a busbar assembly having a complicated structure for electrically conductively connecting the electrically conductive part to the printed circuit board and the inverter is not required. As a result, there is no need for a space for housing the busbar assembly in the inverter, and thus it is possible to miniaturize the electric compressor by decreasing the size of the inverter.

Furthermore, in order to form a space for housing the busbar assembly, there is no need to complicate the internal structure of the inverter.

Accordingly, it is possible to simplify the structure of the inverter chamber inside the inverter as well as to decrease the size of the inverter.

### BRIEF DESCRIPTION OF THE DRAWINGS

FIG. 1 is an exploded perspective view of an electric compressor according to a related art.
FIG. 2 is an exploded perspective view showing a coupling relationship of an inverter of the electric compressor of FIG. 1.
FIG. 3 is an exploded perspective view showing a coupling relationship of the inverter of FIG. 2.
FIG. 4 is a perspective view of an electric compressor according to an embodiment of the present disclosure.
FIG. 5 is an exploded perspective view showing an internal configuration of the electric compressor of FIG. 4.
FIG. 6 is a cross-sectional view of the electric compressor of FIG. 4.
FIG. 7 is an exploded perspective view showing a coupling relationship of an inverter of the electric compressor of FIG. 4.
FIG. 8 is a perspective view showing an electrically conductive member configured to electrically conductively connecting a motor part and the inverter of FIG. 7.
FIG. 9 is a perspective view showing a connection relationship between a printed circuit board of the inverter and the electrically conductive member of FIG. 8.
FIG. 10 is a plan view showing a connection relationship between the printed circuit board of the inverter and the electrically conductive member of FIG. 8.
FIG. 11 is a perspective view showing a connection relationship between the motor part and the electrically conductive member of FIG. 8.
FIG. 12 is a side view illustrating a state in which an elastic member is compressed by vibration generated when the electric compressor of FIG. 4 is operated.
FIG. 13 is a side view illustrating a state in which, based on the state of FIG. 12, the elastic member is stretched and thus the vibration is damped.

### DETAILED DESCRIPTION OF THE INVENTION

An electric compressor 10 according to an embodiment of the present disclosure will be described below in detail with respect to the accompanying drawings.

Hereinafter, in order to clarify the technical features of the present disclosure, the description of some elements may be omitted.

### 1. Definition of Terms

It will be understood that when an element is referred to as being "connected with" another element, the element can be connected with the another element or intervening elements may also be present.

In contrast, when an element is referred to as being "directly connected with" another element, there are no intervening elements present.

A singular representation may include a plural representation unless it represents a definitely different meaning from the context.

The term "conductive material" as used herein refers to a material capable of receiving heat or electricity from another member and transfer heat or electricity to another member. In an embodiment, the conductive material may include iron (Fe), copper (Cu), and the like.

The term "printed circuit board" (PCB) as used herein refers to a substrate for forming an electronic circuit by fixing electronic components such as an integrated circuit, a resistor, and a condenser to a surface of a printed wiring board and by connecting the components by means of wiring or the like.

The term "inverter device" as used herein refers to an electronic circuit element using semiconductor. In an embodiment, the inverter device may be provided as a switching element.

In an embodiment, an inverter element may refer to a component or device that is provided as a switching element to have a function of opening or closing a circuit without using contact points.

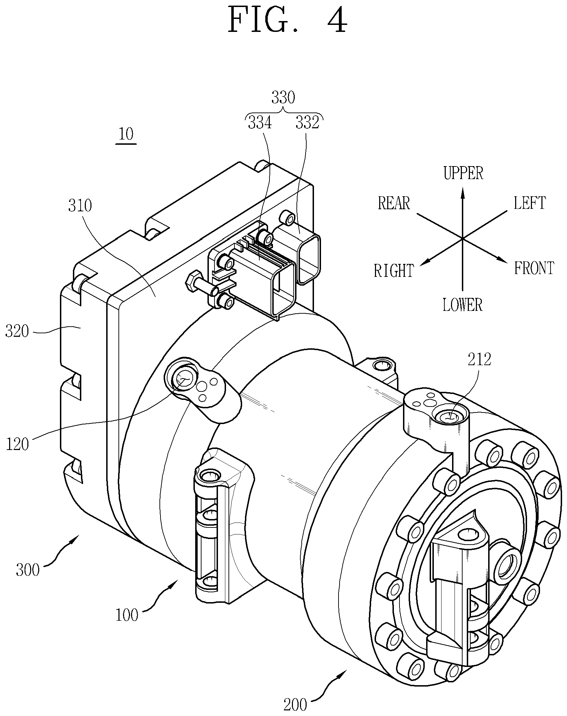

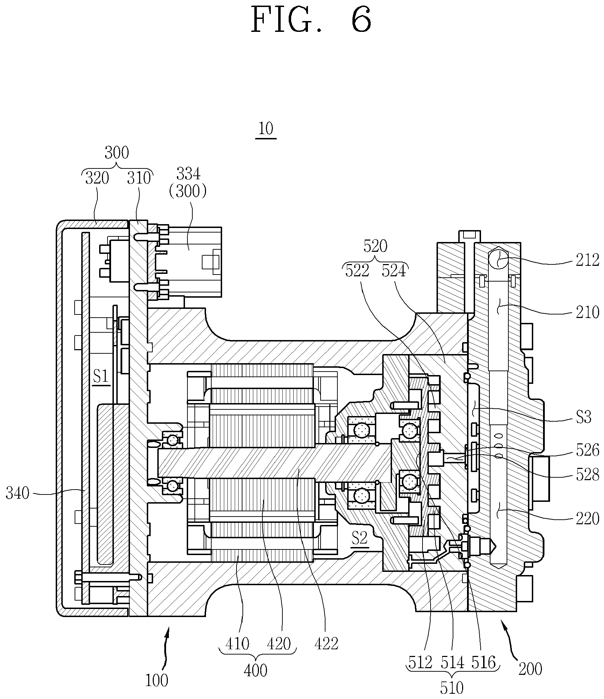

The terms "front," "rear," "upper," "lower," "right," and "left" as used herein will be understood with reference to the coordinate systems shown in FIGS. 4 and 6.

### 2. Description of Configuration of Electric Compressor 10 According to Embodiment of Present Invention

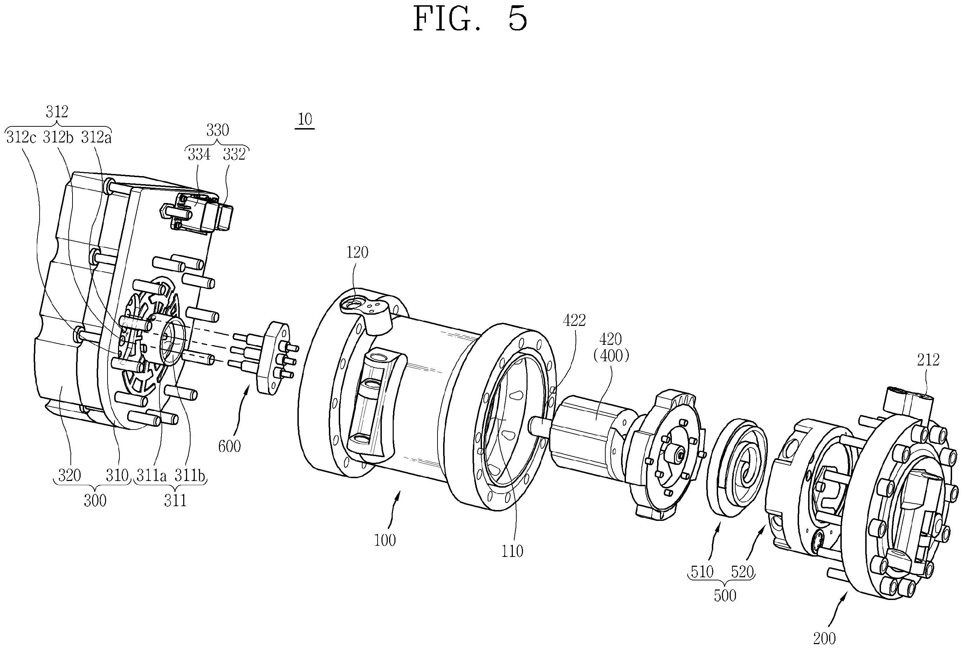

Referring to FIGS. 4 to 6, the electric compressor 10 according to an embodiment of the present disclosure includes a main housing 100, a rear housing 200, an inverter 300, a motor part 400, and a compression part 500.

Also, the electric compressor 10 according to an embodiment of the present disclosure includes an electrically conductive part 600 for electrically conductively connecting the inverter 300 and the motor part 400.

The elements of the electric compressor 10 according to an embodiment of the present disclosure will be described below with reference to FIGS. 4 to 6. However, the electrically conductive part 600 will be described in another section.

### (1) Description of Main Housing 100

The main housing 100 forms a portion of the external appearance of the electric compressor 10. Also, the main housing 100 forms the body of the electric compressor 10 and has a space formed therein.

A device for driving the electric compressor 10 may be housed in the space. In detail, the motor part 400 and the compression part 500 are housed in the inner space of the main housing 100.

In an embodiment that is not shown, a fixed scroll 520 of the compression part 500 may not be housed in the main housing 100. In the above embodiment, the fixed scroll 520 may be located between the main housing 100 and the rear housing 200.

The main housing 100 has a cylindrical shape extending lengthwise, that is, along the front-rear direction in the shown embodiment. The main housing 100 may have any shape capable of housing the motor part 400, the compression part 500, and other devices necessary to drive the electric compressor 10 therein.

However, considering that refrigerant introduced into the main housing 100 is compressed with high pressure and an orbiting scroll 510 is eccentrically rotated, it is preferable that the main housing 100 be formed to have a circular cross-section, which is a shape with high pressure resistance.

The rear housing 200 may be connected in fluid communication with one side in the length direction of the main housing 100, that is, the front side of the main housing 100 in the shown embodiment.

In an embodiment that is not described above, that is, in an embodiment in which the fixed scroll 520 is located between the main housing 100 and the rear housing 200, the main housing 100, the fixed scroll 520, and the rear housing 200 may be connected in fluid communication with one another.

The refrigerant introduced into the main housing 100 may be compressed by the compression part 500 that is rotated when the motor part 400 is driven. The compressed refrigerant is introduced into a discharge chamber S3 through a discharge port 528 formed at the fixed scroll 520.

The inverter 300 is electrically conductively connected to the other side in the length direction of the main housing 100, that is, the rear side of the main housing 100 in the shown embodiment.

Power and a control signal applied by the inverter 300 are transferred to the motor part 400. The motor part 400 is driven by the transferred power and control signal to generate a rotational force to be used by the compression part 500 to compress refrigerant.

The main housing 100 includes a motor chamber 110 and an intake port 120.

The motor chamber 110 is a space where the motor part 400 is housed. The motor chamber 110 may be defined as an inner space of the main housing 100. In other words, the motor chamber 110 is a space partitioned by an inner circumferential surface of the main housing 100.

Alternatively, the motor chamber 110 may be housed in the main housing 100 and may be provided as a separate housing having a space formed therein. In this case, the separately provided housing may be brought in contact with the inner circumferential surface of the main housing 100.

When the motor part 400 is housed in the motor chamber 110, an outer circumferential surface of a stator 410 of the motor part 400 may be fixed on an inner circumferential surface of the motor chamber 110. Accordingly, the stator 410 may stably remain stationary even when power and a control signal are applied from the inverter 300 to the motor part 400.

In an embodiment that is not shown, a protrusion (not shown) may be formed on the inner circumferential surface of the motor chamber 110, and a blind hole (not shown) may be formed on the stator 410. When the motor part 400 is housed in the motor chamber 110, the protrusion (not shown) and the blind hole (not shown) may be in engagement with each other.

In this case, the direction in which the motor part 400 is housed in the motor chamber 110 is limited, and this it is possible to prevent the motor part 400 from being housed in a wrong direction.

The intake port 120 enables the inside and outside of the main housing 100 to communicate with each other. The refrigerant outside the electric compressor 10 may be introduced into the main housing 100 through the intake port 120. The introduced refrigerant is compressed by passing through the motor chamber 110, a back-pressure chamber S2, and the discharge chamber S3 in sequence and then is discharged to the outside of the electric compressor 10 through an exhaust port 212 of the rear housing 200.

The intake port 120 may be formed through the outer circumferential surface of the main housing 100. In the shown embodiment, the intake port 120 is located on one side of the main housing 100 opposite to the rear housing 200. In other words, the intake port 120 is located on one side of the main housing 100 adjacent to the inverter 300.

Also, the intake port 120 is formed as a circular through-hole passing through the main housing 100.

The location and shape of the intake port 120 may be formed in any form capable of enabling the inside and the outside of the housing 100 to communicate with each other and allowing refrigerant to be introduced into the main housing 100.

As will be described later, however, a large amount of heat is generated in the inverter device 350 housed in the inverter 300. Also, the refrigerant introduced into the main housing 100 may be configured to cool the large amount of heat to some extent.

In consideration of this point, it is preferable that the intake port 120 be located adjacent to the inverter 300.

### (2) Description of Rear Housing 200

The rear housing 200 forms a portion of the external appearance of the electric compressor 10. In detail, the rear housing 200 is located on one side of the main housing 100, that is, in front of the main housing 100 in the shown embodiment to form a front appearance of the electric compressor 10.

Alternatively, the fixed scroll 520 of the compression part 500 may be located between the rear housing 200 and the main housing 100.

The rear housing 200 may be configured to communicate with the main housing 100. Refrigerant introduced into the main housing 100 through the intake port 120 of the main housing 100 may be compressed in the compression part 500 and then discharged to the outside through the rear housing 200.

In the shown embodiment, the rear housing 200 has the shape of a cap having a circular cross-section. The shape of the rear housing 200 is changeable.

However, the rear housing 200 and the main housing 100 should be combined with each other to communicate with each other while sealed from the outside. Considering this point, it is preferable that the rear housing 200 should have a shape corresponding to the shape of the main housing 100.

The rear housing 200 and the main housing 100 may be combined with each other through a separate fastening means (not shown). The fastening means (not shown) may combine and seal the rear housing 200 and the main housing 100.

The rear housing 200 includes an exhaust flow path 210 and an oil discharge flow path 220.

The exhaust flow path 210 is a passage through which the refrigerant compressed by the compression part 500 is to be discharged. The exhaust flow path 210 communicates with the discharge chamber S3.

The exhaust port 212 configured to enable the inside and outside of the rear housing 200 to communicate with each other may be formed on one end of the exhaust flow path 210, that is, an upper end of the exhaust flow path 210 in the shown embodiment. In an embodiment, the exhaust port 212 may be formed as a through-hole.

The refrigerant compressed in the compression part 500 enters the exhaust flow path 210 through the discharge chamber S3. In this case, the refrigerant introduced into the exhaust flow path 210 is mixed with oil. When oil remains in the refrigerant discharged through the exhaust port 212, cooling efficiency of an air conditioning system can be reduced. Furthermore, the oil may cause an apparatus included in the air conditioning system to be damaged.

Thus, a cyclone apparatus (not shown) or the like configured to separate oil from refrigerant may be provided inside the exhaust flow path 210.

The oil discharge flow path 220 is a flow path through which the oil separated from the refrigerant moves. The oil discharge flow path 220 communicates with the exhaust flow path 210. A residual mixture of the refrigerant and the oil or the oil separated from the refrigerant in the exhaust flow path 210 may move to a lower side of the rear housing 200 through the oil discharge flow path 220.

The oil discharge flow path 220 communicates with an oil flow path part (not shown). The residual mixture of the refrigerant and the coil or the oil moving to the lower side of the rear housing 200 may move back to the compression part 500 through the oil flow path part (not shown).

### (3) Description of Inverter 300

The inverter 300 is configured to control operation of the electric compressor 10. In detail, the inverter 300 controls operation of the electric compressor 10 by applying or releasing power a control signal to the motor part 400.

The inverter 300 may receive the power and the control signal from the outside of the electric compressor 10. To this end, the inverter 300 is electrically conductively connected to a control unit (not shown) located outside the electric compressor 10.

The inverter 300 may apply the received power and control signal to the motor part 400. To this end, the inverter 300 may be electrically conductively connected to the motor part 400.

The electric compressor 10 according to an embodiment of the present disclosure includes an electrically conductive part 600 for simply forming electrically conductive connection between the inverter 300 and the motor part 400. This will be described in detail below.

The inverter 300 is located on one side of the main housing 100. In detail, the inverter 300 is located on one side of the main housing 100 opposite to the rear housing 200.

The inverter 300 may be electrically conductively connected to the motor part 400 and may be provided at any position to which the power and control signal can be applied.

In an embodiment that is not shown, the inverter 300 may communicate with the main housing 100. In the above embodiment, a portion of the refrigerant introduced through the intake port 120 may be introduced into the inverter 300 to directly cool the inverter device 350.

The inverter 300 includes an inverter housing 310, an inverter cover 320, an inverter connector 330, a printed circuit board 340, and an inverter device 350.

The inverter housing 310 forms the external appearance of the inverter 300 together with the inverter cover 320. In detail, the inverter housing 310 is a part where the inverter 300 is coupled to the main housing 100.

The inverter housing 310 is located on one side of the inverter 300 facing the main housing 100.

It is preferable that the inverter housing 310 be formed of a high thermal conductivity material. This is to effectively cool the inverter device 350 housed in the inverter 300 through heat exchange with the refrigerant introduced into the main housing 100.

The refrigerant introduced into the intake port 120 may be configured to cool the inverter device 350 through heat change with the inverter housing 310.

The inverter cover 320 is coupled to one side of the inverter housing 310 opposite to the main housing 100, that is, the rear side of the inverter housing 310 in the shown embodiment.

A space formed by coupling the inverter housing to the inverter cover 320 may be defined as an inverter chamber S1. The printed circuit board 340 and the inverter device 350 are housed in the inverter chamber S1. ALSO, any devices that are not shown may be housed in the inverter chamber S1 to input and output power and a control signal.

The inverter connector 330 is located above the inverter housing 310. The inverter connector 330 is configured to receive power and a control signal from the outside.

The inverter housing 310 includes a rotary shaft support part 311 and a connector coupling part 312.

The rotary shaft support part 311 is a part to which a rotary shaft 422 of the motor part 400 is to be coupled. The rotary shaft support part 311 is not rotated irrespective of the rotation of the rotary shaft 422. The rotary shaft 422 may be coupled to the rotary shaft support part 311 and may be freely rotated. That is, the rotary shaft support part 311 is configured to support one end of the rotary shaft 422, that is, one end facing the inverter 300.

The rotary shaft support part 311 is formed on one surface of the inverter housing 310 facing the main housing.

A circular blind hole 311a may be formed on the rotary shaft support part 311 such that the rotary shaft 422 can be inserted into the blind hole 311a.

A guide part 311b protruding from one surface of the inverter housing 310 may be formed on an outer circumference of the rotary shaft support part 311 and may be configured to support the rotary shaft 422.

It is preferable that a central axis of the rotary shaft support part 311 be formed coaxially with the stator 410 and the rotor 420 of the motor part 400. Thus, the rotor 420 may be stably rotated.

The connector coupling part 312 is a part to which the electrically conductive part 600 is to be coupled. The connector coupling part 312 includes a support member insertion blind hole 312a, an input terminal insertion hole 312b, and a fastening hole 312c.

A support member 610 of the electrically conductive part 600 is inserted into and coupled to the support member insertion blind hole 312a. The support member insertion blind hole 312a is recessed a predetermined distance from one surface of the inverter housing 310 facing the main housing 100.

The shape and recessed distance of the support member insertion blind hole 312a may be determined according to the shape of the support member 610 of the electrically conductive part 600.

In an embodiment, the support member insertion blind hole 312a may be configured to perfectly house the support member 610. That is, one surface of the support member 610 facing the main housing 100 may be coplanar with one surface of the inverter housing 310 facing the main housing 100.

An input terminal 621 of the electrically conductive part 600 may be inserted into and coupled to the input terminal insertion hole 312b. The input terminal 621 is electrically conductively connected to the printed circuit board 340 and the inverter device 350 housed in the inverter chamber S1.

Accordingly, the input terminal insertion hole 312b may be formed through the inverter housing 310. The input terminal 621 may be inserted into and through the input terminal insertion hole 312b and thus may be electrically conductively connected to the printed circuit board 340 and the inverter device 350.

A connection member 630 of the electrically conductive part 600 may also be inserted into and coupled to the input terminal insertion hole 312b. To this end, the diameter of the cross section of the input terminal insertion hole 312b may be equal to or larger than the outer diameter of the cross section of the connection member 630.

When the coupling between the electrically conductive part 600 and the inverter 300 is complete, the input terminal 621 of the electrically conductive part 600 is electrically conductively connected to the printed circuit board 340 and the inverter device 350 through the input terminal insertion hole 312b. Also, the connection member 630 of the electrically conductive part 600 is inserted into the input terminal insertion hole 312b.

In the shown embodiment, a total of three input terminal insertion holes 312b are formed and spaced a predetermined distance from one another in the length direction of the connector coupling part 312.

This is due to the fact that an electric current applied to the electric compressor 10 according to an embodiment of the present disclosure is a three-phase current, as will be described later. In an embodiment, currents of U phase, V phase, and W phase may be applied to the electric compressor 10 according to an embodiment of the present disclosure.

The number of input terminal insertion holes 312b may be changed depending on the number and types of phases applied to the electric compressor 10.

A fastening member (not shown) for coupling the inverter 300 to the electrically conductive part 600 is inserted into and coupled to the fastening hole 312c. In this case, the fastening hole 312c may be recessed a predetermined distance from one surface of the connector coupling part 312 facing the main housing 100.

In an embodiment, a fastening member (not shown) may be inserted through and coupled to the fastening hole 312c. In this case, the fastening hole 312c may be formed through the inverter housing 310.

The fastening member (not shown) may be any member capable of coupling two or more different members such as a screw or a rivet.

In the shown embodiment, two fastening holes 312c are formed on the support member insertion blind hole 312a. In detail, the fastening holes 312c are spaced a predetermined distance from each other and may be located outward from the input terminal insertion holes 312b located at the outermost sides among the input terminal insertion holes 312b formed along the length direction of the support member insertion blind hole 312a.

The number and locations of fastening holes 312c may be determined to correspond to the number and shape of fastening holes 612 of the support member 610.

The inverter cover 320 forms the external appearance of the inverter 300 together with the inverter housing 310. The inverter cover 320 is located on one side of the inverter housing 310 opposite to the main housing 100, that is, the rear side of the inverter housing 310 in the shown embodiment.

The inverter cover 320 is coupled to the inverter housing 310. A certain space is formed between the inverter cover 320 and the inverter housing 310 coupled to each other. The space may be defined as the inverter chamber S1 where the printed circuit board 340, the inverter device 350, and the like are to be housed.

The inverter cover 320 may be coupled to the inverter housing 310 by a separate fastening means (not shown).

The inverter connector 330 is configured to receive power and a control signal from the outside of the electric compressor 10. The power and control signal received by the inverter connector 330 may be transferred to the motor part 400 to drive the motor part 400.

In the shown embodiment, the inverter connector 330 may be located above the inverter housing 310. The inverter connector 330 may be provided at any location capable of receiving power and a control signal from the outside.

The inverter connector 330 includes a communication connector 332 for receiving a control signal and a power connector 334 for receiving a power signal. Alternatively, the inverter connector 330 may be provided as a single connector and configured to receive power and a control signal through one connector.

A process of calculating the power and control signal transferred to the inverter device 350 housed in the inverter chamber S1 through the inverter connector 330 is well known in the art, and thus a detailed description thereof will be omitted.

The printed circuit board 340 generates power and control signal to be transferred to the motor part 400 together with the inverter device 350. In detail, the printed circuit board 340 and the inverter device 350 are configured to convert the power and control signal transferred from the outside into power and a control signal for driving the motor part 400.

Also, the printed circuit board 340 and the inverter device 350 may be configured to acquired information regarding the motor part 400 being driven and transfer the information to an external control unit (not shown).

The printed circuit board 340 and the inverter device 350 may be electrically conductively connected to the external control unit (not shown). Also, the printed circuit board 340 and the inverter device 350 may be electrically conductively connected to each other.

The printed circuit board 340 includes an input terminal housing part 341 and an input terminal connection part 342.

The input terminal housing part 341 houses the input terminal 621 of the electrically conductive part 600. In the shown embodiment, the input terminal housing part 341 is formed in the form of a through-hole. The input terminal housing part 341 may be formed in any form capable of housing the input terminal 621.

In the shown embodiment, the input terminal housing part 341 includes a first input terminal housing part 342a, a second input terminal housing part 342b, and a third input terminal housing part 342c. A first input terminal 621a, a second input terminal 621b, and a third input terminal 621c are housed in the input terminal housing parts 342a, 342b, and 342c, respectively.

This is due to the application of a three-phase current to the electric compressor 10 according to an embodiment of the present disclosure.

The locations and number of input terminal housing parts 341 may be changed to correspond to the locations and number of input terminals 621.

When the input terminal 621 is housed in the input terminal housing part 341, the input terminal 621 may be fixed on the input terminal housing part 341 by a method such as soldering.

The input terminal connection part 342 is in contact with the input terminal 621 to electrically conductively connect the inverter 300 to the electrically conductive part 600.

In the shown embodiment, the input terminal connection part 342 is provided in the input terminal housing part 341. The input terminal connection part 342 may have any shape capable of being brought in contact with the input terminal 621 housed in the input terminal housing part 341.

One side of the input terminal connection part 342 may be electrically conductively connected to the printed circuit board 340. Accordingly, when the input terminal 621 is in electrically conductive contact with the input terminal connection part 342, the input terminal 621 may be electrically conductively connected to the printed circuit board 340 and the inverter device 350.

A through-hole may be formed in the input terminal connection part 342. The input terminal 621 is inserted through and coupled to the through-hole. The location and shape of the through-holes may be determined depending on the location and shape of the input terminal 621.

The input terminal connection part 342 may be formed of a conductive material. In an embodiment, the input terminal connection part 342 may be formed of iron, copper, an alloy of iron and nickel, an alloy of copper and nickel, or the like.

When the input terminal 621 is housed in the input terminal housing part 341, the input terminal 621 is in contact with the input terminal connection part 342. Subsequently, the input terminal 621 and the input terminal connection part 342 may remain in contact with each other through a method such as soldering.

### (4) Description of Motor Part 400

The motor part 400 generates a rotational force for rotating the compression part 500 to compress refrigerant. To this end, the motor part 400 is rotatably connected to the orbiting scroll 510 of the compression part 500.

The motor part 400 is electrically conductively connected to the inverter 300. The motor part 400 may be configured to receive power and a control signal from the inverter 300. This will be accomplished by the electrically conductive part 600 to be described later.

The motor part 400 is housed in the motor chamber 110 of the main housing 100. In detail, the motor part 400 is housed in the motor chamber 110 such that an outer circumferential surface of the stator 410 forming the outside of the motor part 400 is in contact with an inner circumferential surface of the motor chamber 110.

Thus, when the power and control signal are applied from the inverter 300, only the rotor 420 may be rotated while the stator 410 is not rotated.

The motor part 400 includes the stator 410, the rotor 420, and an output terminal housing part 430.

The stator 410 forms an electromagnetic field according to the power and control signal applied by the inverter 300. The formed electric field affects an electromagnetic force to a magnet included in the rotor 420. Accordingly, the rotor 420 may be rotated, and thus the orbiting scroll 510 may be rotated.

The stator 410 includes a plurality of coils (not shown). The plurality of coils (not shown) are wounded around the stator 410. An electric current having a different phase flows through each of the plurality of coils (not shown). In an embodiment, an electric current having any one of U phase, V phase, and W phase may flow through each of the coils (not shown).

The stator 410 forms the outside of the motor part 400. When the motor part 400 is housed in the motor chamber 110, the outer circumferential surface of the stator 410 is brought in contact with the inner circumferential surface of the motor chamber 110.

The stator 410 may be housed and fixed in the motor chamber 110. Even when the power and control signal are transferred from the inverter 300 and the motor part 400 is operated, the stator 410 is not rotated.

A certain space is formed inside the stator 410. In the shown embodiment, the stator 410 has a cylindrical shape extending lengthwise. A hollow portion extending lengthwise is formed inside the stator 410. The certain space is defined by the hollow portion.

The rotor 420 is housed in the hollow portion. The rotor 420 is spaced a predetermined distance from the stator 410. The rotor 420 and the stator 410 are not in contact with each other.

The output terminal housing part 430 is provided on one side of the stator 410 facing the main housing 100, that is, the rear side of the stator 410 in the shown embodiment. The output terminal housing part 430 is electrically conductively connected to the electrically conductive part 600.

The rotor 420 is rotated by an electromagnetic field formed by the plurality of coils (not shown) provided in the stator 410. The rotor 420 includes a plurality of magnets.

When the plurality of coils (not shown) of the stator 410 forms an electromagnetic field, the plurality of magnets of the rotor 420 receive an electromagnetic force. By the electromagnetic force, the rotor 420 is rotated clockwise or counterclockwise.

The rotor 420 is housed in a space formed inside the stator 410. The rotor 420 is spaced a predetermined distance from the stator 410. That is, an outer circumferential surface of the rotor 420 and an inner circumferential surface of the stator 410 are not in contact with each other.

Accordingly, the rotor 420 may be rotated relative to the stator 410, irrespectively of the stator 410.

The rotor 420 is rotatably connected to the orbiting scroll 510 of the compression part 500. The rotor 420 is rotated integrally with the orbiting scroll 510.

The rotor 420 includes the rotary shaft 422.

The rotary shaft 422 is configured to transfer the rotation of the rotor 420 to the orbiting scroll 510. The orbiting scroll 510 is rotatably coupled to one side of the rotary shaft 422 facing the rear housing 200, that is, the front side of the rotary shaft 422 in the shown embodiment.

That is, the rotary shaft 422 and the orbiting scroll 510 is coupled to each other such that the orbiting scroll 510 is integrally rotated when the rotary shaft 422 is rotated.

The other side of the rotary shaft 422 facing the inverter 300, that is, the rear side of the rotary shaft 422 is inserted into the rotary shaft support part 311 of the inverter 300. The rotary shaft support part 311 supports the rotary shaft 422, but is not rotated irrespective of the rotation of the rotary shaft 422.

Accordingly, the rotary shaft 422 may rotate the orbiting scroll 510 along with the rotation of the rotor 420 while stably supported by the rotary shaft support part 311.

The output terminal housing part 430 electrically conductively connect the electrically conductive part 600 to the stator 410. The power and control signal applied by the inverter 300 are transferred to the output terminal housing part 430 through the electrically conductive part 600.

An output terminal 622 of the electrically conductive part 600 is electrically conductively housed in the output terminal housing part 430. Also, the output terminal 622 may be detachably housed in the output terminal housing part 430.

The power and control signal transferred to the output terminal housing part 430 are transferred to the stator 410. The output terminal housing part 430 and the stator 410 may be electrically conductively connected to each other by a member such as a conducting wire (not shown).

In the shown embodiment, the output terminal housing part 430 is located on one side of the motor part 400 facing the inverter 300.

In the shown embodiment, the output terminal housing part 430 includes an output terminal insertion part 431 into which the output terminal 622 is to be inserted. The output terminal insertion part 431 may be formed in a space where an opening is formed on one side facing the inverter 300.

A conductive member may be provided in the output terminal insertion part 431. That is, when the output terminal 622 is inserted into the output terminal insertion part 431, a conductive member configured to occupy a space other than a space occupied by the output terminal 622 out of the space of the output terminal insertion part 431 may be provided.

In the shown embodiment, the output terminal insertion part 431 may include three parts, that is, a first output terminal insertion part 431a, a second output terminal insertion part 431b, and a third output terminal insertion part 431c. This is due to the application of a three-phase current to the electric compressor 10 according to an embodiment of the present disclosure, as described above.

The number of output terminal insertion parts 431 provided in the output terminal housing part 430 may be changed depending on the number of output terminals 622 of the electrically conductive part 600 and the number of phases of the applied current.

Also, the sizes and shapes of the output terminal insertion parts 431a, 431b, and 431c may be changed to correspond to the size and shape of the output terminal 622 of the electrically conductive part 600.

### (5) Description of Compression Part 500

The compression part 500 is rotated by a rotational force generated by the motor part 400 to substantially serve to compress refrigerant.

The compression part 500 is rotatably connected to the rotor 420 by the rotary shaft 422. When the rotor 420 is rotated, the rotary shaft 422 and the compression part 500 are integrally rotated.

The compression part 500 includes the orbiting scroll 510 and the fixed scroll 520.

The orbiting scroll 510 is rotated along with the rotation of the motor part 400. The orbiting scroll 510 is rotatably coupled to the rotary shaft 422 of the rotor 420. That is, when the rotary shaft 422 is rotated, the orbiting scroll 510 is also integrally rotated.

The orbiting scroll 510 has a central axis different from those of the rotor 420 and the rotary shaft 422. When the rotor 420 is rotated, the orbiting scroll 510 is rotated eccentrically with respect to the central axis of the rotor 420.

On the other hand, the fixed scroll 520 has the same central axis as the rotor 420. Accordingly, the orbiting scroll 510 is rotated eccentrically with respect to the central axis of the fixed scroll 520.

Thus, refrigerant introduced between a fixed wrap 524 of the fixed scroll 520 and an orbiting wrap 514 of the orbiting scroll 510 may be compressed.

The orbiting scroll 510 is housed in the main housing 100. Also, the orbiting scroll 510 may be housed to be eccentrically rotatable in the space inside the main housing 100.

The orbiting scroll 510 may be located on one side of the motor chamber 110 adjacent to the rear housing 200, that is, the front side of the motor chamber 110 in the shown embodiment.

The orbiting scroll 510 includes an orbiting end plate part 512, the orbiting wrap 514, and a rotary shaft coupling part 516.

The orbiting end plate part 512 forms the body of the orbiting scroll 510. In the shown embodiment, the orbiting end plate part 512 forms the rear side of the orbiting scroll 510.

One surface of the orbiting end plate part 512, that is, the front surface of the orbiting end plate part 512 in the shown embodiment may be in contact with the rear surface of the fixed wrap 524 of the fixed scroll 520.

The orbiting wrap 514 is coupled to the fixed wrap 524 of the fixed scroll 520 with a predetermined space formed therebetween. The orbiting wrap 514 may be rotated eccentrically with respect to the rotary shaft 422 while coupled to the fixed wrap 524. Thus, refrigerant introduced into the space between the orbiting wrap 514 and the fixed wrap 524 may be compressed.

The orbiting wrap 514 is formed to protrude from the orbiting end plate part 512. In the shown embodiment, the orbiting wrap 514 is formed to protrude in a direction facing the rear housing 200.

In the shown embodiment, the orbiting wrap 514 is spirally formed. The orbiting wrap 514 may have any shape capable of being coupled in engagement with the fixed wrap 524 and eccentrically rotated relative to the fixed wrap 524.

The rotary shaft coupling part 516 is a part where the rotary shaft 422 of the rotor 420 is to be coupled to the orbiting scroll 510.

The rotary shaft coupling part 516 is formed through the orbiting end plate part 512. In the shown embodiment, the rotary shaft coupling part 516 is formed through the orbiting end plate part 512 in the front-rear direction thereof.

An eccentric part (not shown) may be coupled to the rotary shaft coupling part 516. The eccentric part (not shown) is configured to change the rotary shaft of the orbiting scroll 510 such that the orbiting scroll 510 is rotated eccentrically with respect to the rotary shaft 422.

The fixed scroll 520 is not rotated irrespective of the rotation of the motor part 400. Accordingly, when the motor part 400 is operated, the orbiting scroll 510 may be rotated relative to the fixed scroll 520.

The fixed scroll 520 is housed in the main housing 100. In detail, the fixed scroll 520 may have one side located adjacent to the orbiting scroll 510 and the other side located adjacent to the rear housing 200.

In an embodiment that is not shown, the fixed scroll 520 may be exposed to the outside of the electric compressor 10. In the above embodiment, the fixed scroll 520 may be located between the main housing 100 and the rear housing 200.

One surface of the fixed scroll 520 adjacent to the rear housing 200, that is, the front surface of the fixed scroll 520 is coupled to the rear housing 200 with a predetermined space formed therebetween. The space formed between the fixed scroll 520 and the rear housing 200 may be defined as the discharge chamber S3 through which refrigerant passes before entering the exhaust flow path 210.

The fixed scroll 520 is relatively rotatably coupled to the orbiting scroll 510. As described above, the orbiting scroll 510 is rotated relative to the fixed scroll 520 because the fixed scroll 520 remains fixed.

The fixed scroll 520 includes a fixed end plate part 522, the fixed wrap 524, a discharge valve 526, and a discharge port 528. Also, a rotary shaft coupling part (not shown) is formed in the fixed scroll 520, and thus the rotary shaft 422 may be rotatably coupled to the rotary shaft coupling part.

However, as described above, the fixed scroll 520 is not rotated along with the rotation of the rotary shaft 422. Therefore, it can be seen that the rotary shaft coupling part (not shown) provided in the fixed scroll 520 supports one side of the rotary shaft 422.

The fixed end plate part 522 forms the body of the fixed scroll 520. In the shown embodiment, the fixed end plate part 522 forms the front side of the fixed scroll 520.

One surface of the fixed end plate part 522, that is, the rear surface of the fixed end plate part 522 in the shown embodiment may be in contact with the front surface of the orbiting wrap 514 of the orbiting scroll 510.

In the shown embodiment, a plurality of blind holes are formed on the outer circumferential surface of the fixed end plate part 522. The blind holes are intended to reduce the weight of the electric compressor 10, and the shape and number thereof may be changed.

The fixed wrap 524 is coupled to the orbiting wrap 514 of the orbiting scroll 510 with a predetermined space formed therebetween. That is, the fixed wrap 524 is spaced a predetermined distance from and engaged with the orbiting wrap 514.

When the orbiting scroll 510 is rotated by the motor part 400 after the fixed wrap 524 is coupled to the orbiting wrap 514, refrigerant may be compressed in the space between the fixed wrap 524 and the orbiting wrap 514.

The fixed wrap 524 is formed to protrude from the fixed end plate part 522. In the shown embodiment, the fixed wrap 524 is formed to protrude rearward from the fixed end plate part 522.

In the shown embodiment, the fixed wrap 524 is spirally formed. The fixed wrap 524 may have any shape capable of being coupled in engagement with the orbiting wrap 514 such that the orbiting wrap 514 is rotated relatively eccentrically with respect to the fixed wrap 524.

The discharge valve 526 is configured to open or close the discharge port 528, which is a passage through which refrigerant compressed by the relative rotation between the orbiting scroll 510 and the fixed scroll 520 is to be introduced into the discharge chamber S3.

In an embodiment, the discharge valve 526 may be provided as a check valve such as a reed valve that restricts a flow of fluid in a single direction depending on the pressure.

The discharge valve 526 is located on one side of the fixed end plate part 522 opposite to the fixed wrap 524, that is, on the front side of the fixed end plate part 522 in the shown embodiment. Also, the discharge valve 526 is configured to cover the discharge port 528.

When the pressure of the compressed refrigerant is greater than or equal to a predetermined pressure, the discharge valve 526 opens the discharge port 528. Thus, the compressed refrigerant may be introduced into the discharge chamber S3.

When the pressure of the compressed refrigerant is less than a predetermined pressure, the discharge valve 526 closes the discharge port 528. Thus, the less compressed refrigerant is prevented from being introduced into the discharge chamber S3.

The discharge port 528 is a passage through which the compressed refrigerant is to be introduced into the discharge chamber S3 by the orbiting scroll 510 and the fixed scroll 520. The discharge port 528 connects the space formed between the orbiting wrap 514 and the fixed wrap 524 in fluid communication with the discharge chamber S3.

The discharge port 528 is opened or closed. In detail, the discharge valve 526 is provided in the discharge port 528 and may be opened or closed depending on the pressure of the compressed refrigerant.

The refrigerant discharged through the discharge port 528 is discharged to the outside of the electric compressor 10 through the exhaust port 212 via the discharge chamber S3 and the exhaust flow path 210 in sequence.

In addition to the above elements, the electric compressor 10 according to an embodiment of the present disclosure may include various elements for compressing refrigerant.

Also, although not shown, a refrigerant flow path through which refrigerant is introduced, compressed, and then discharged to the outside of the electric compressor 10, and a member for forming the refrigerant flow path may be provided.

Likewise, although not shown, an oil flow path through which oil is supplied to the compression part 500 and through which oil compressed in the compression part together with refrigerant is supplied back to the compression part 500 after the oil is discharged to the rear housing 200 through the oil discharge flow path 220, and a member for forming the oil flow path may be provided.

### 3. Description of Electrically conductive part 600 According to Embodiment of Present Invention

The electric compressor 10 according to an embodiment of the present disclosure includes the electrically conductive part 600 for electrically conductively connecting the inverter 300 and the motor part 400. The electrically conductive part 600 may be detachably coupled to the inverter 300 and the motor part 400.

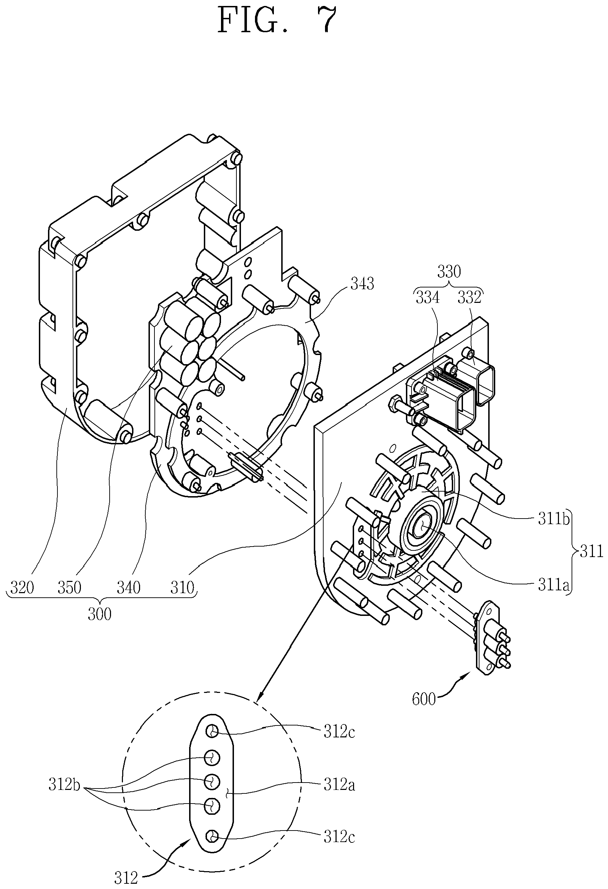

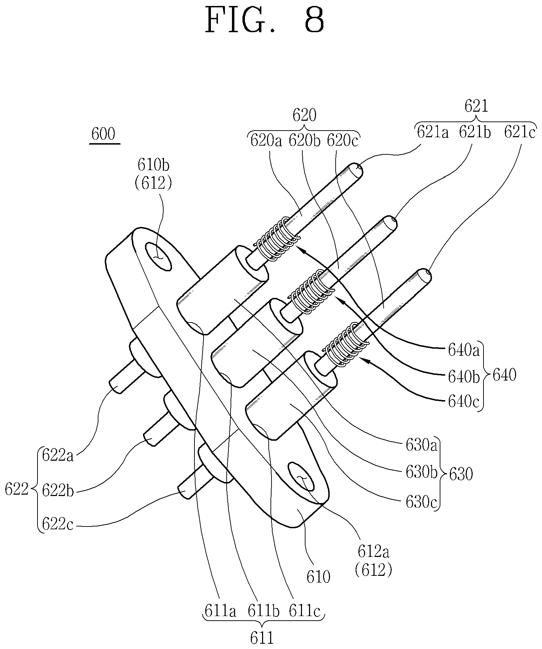

The electrically conductive part 600 according to an embodiment of the present disclosure will be described in detail below with reference to FIGS. 7 to 10.

The electrically conductive part 600 electrically conductively connects the inverter 300 and the motor part 400. Thus, power and a control signal may be applied from the inverter 300 to the motor part 400.

Also, the electrically conductive part 600 may be detachably coupled to the inverter 300 and the motor part 400. Thus, the inverter 300 and the motor part 400 may be electrically conductively connected to each other through a simple structure.

Since the electrically conductive part 600 is provided, the electric compressor 10 according to an embodiment of the present disclosure does not need a complicated wiring structure for electrically conductively connecting the inverter 300 and the motor part 400.

Also, the electrically conductive part 600 is in contact with the inverter device 350 such that they are electrically conductive to each other. Accordingly, there is no need to provide a busbar assembly requiring an inverter according to the prior art.

In the shown embodiment, the electrically conductive part 600 includes a support member 610, a terminal member 620, a connection member 630, and an elastic member 640.

The following description assumes that the input terminal 621 and the output terminal 622 are provided as a single electrically-conductive terminal. That is, one side and the other side of the electrically conductive terminal are defined as the input terminal 621 and the output terminal 622, respectively.

Alternatively, the input terminal 621 and the output terminal 622 may be provided as separate terminals and electrically conductively connected to each other in the support member 610.

### (1) Description of Support Member 610

The support member 610 forms the body of the electrically conductive part 600. The terminal member 620 is inserted into and electrically conductively coupled to the support member 610.

Alternatively, the input terminal 621 and the output terminal 622, which are provided as separate terminals, may be inserted into and coupled to the support member 610. In the above embodiment, the input terminal 621 and the output terminal 622 may be in electrically conductive contact with each other while inserted into and coupled to the support member 610.

When the electrically conductive part 600 is coupled to the inverter 300, the support member 610 is inserted into and coupled to the support member insertion blind hole 312a of the inverter 300. In an embodiment, the support member 610 may be coupled to and wholly housed in the support member insertion blind hole 312a.

That is, one surface of the support member 610 facing the main housing 100 may be coplanar with one surface of the inverter housing 310 facing the main housing 100.

In the shown embodiment, the support member 610 is formed to extend in the width direction, and both ends in the width direction, that is, the vertical direction in the shown embodiment may be formed as a curved surface. The support member 610 may have any shape capable of supporting the coupled terminal member 620 and electrically conductively coupling to the inverter 300 and the motor part 400.

It is preferable that the support member 610 be formed of a non-conductive material so as to prevent power and a control signal applied through the terminal member 620 from being leaked or mixed with noise unintentionally.

The support member 610 includes a terminal coupling part 611 and a fastening hole 612.

The terminal member 620 is inserted through and coupled to the terminal coupling part 611. Also, the connection member 630 is inserted through and coupled to the terminal coupling part 611.

The terminal coupling part 611 is formed through the support member 610 in the length direction, that is, in the front-rear direction in the shown embodiment.

In the shown embodiment, a total of three terminal coupling parts 611, that is, a first terminal coupling part 611a, a second terminal coupling part 611b, and a third terminal coupling part 611c are formed in the support member 610 and spaced a predetermined distance from one another. This is due to the application of a three-phase current to the electric compressor 10 according to an embodiment of the present disclosure, as described above.

The number of terminal coupling parts 611 may be changed depending on the number of phases of the applied current. Also, the location of the terminal coupling part 611 may be changed to correspond to the location of the input terminal insertion hole 312b of the inverter housing 310.

In the shown embodiment, the terminal coupling part 611 may be formed to have a circular cross section. This is due to the circular cross-sectional shape of the terminal member 620 and the connection member 630 which are inserted through and coupled to the terminal coupling part 611.

The shape of the terminal coupling part 611 may be changed depending on the cross-sectional shape of the terminal member 620 and the connection member 630.

The fastening hole 612 is a space into which a fastening member (not shown) for fastening the electrically conductive part 600 and the inverter 300 is to be inserted. In the shown embodiment, the fastening hole 612 includes a first fastening hole 612a located on one side in the width direction of the support member 610 and a second fastening hole 612b located on the other side opposite to the one side.

The number and locations of fastening holes 612 may be changed to correspond to the number and locations of fastening holes 312c formed in the inverter housing 310.

After the electrically conductive part 600 is coupled to the inverter 300, a fastening member (not shown) is inserted into and through the fastening hole 612 and the fastening hole 312c so that the electrically conductive part 600 and the inverter 300 are fastened to each other. Thus, the electrically conductive part 600 and the inverter 300 may stably remain coupled to each other.

### (2) Description of Terminal Member 620

The terminal member 620 is an electrical passage through which the power and control signal applied by the inverter 300 are transferred to the motor part 400. The terminal member 620 electrically conductively connects the inverter 300 and the motor part 400.

The terminal member 620 is formed to extend lengthwise. One side of the terminal member 620 adjacent to the inverter 300 may be defined as the input terminal 621. Likewise, one side of the terminal member 620 adjacent to the motor part 400 may be defined as the output terminal 622.

The terminal member 620 may be formed of a conductive material such as iron (Fe), copper (Cu), an alloy of iron and nickel (Ni), an alloy of copper and nickel, or the like. In an embodiment, the terminal member 620 may be formed of Fe-Ni 50% alloy (an iron alloy with 50% nickel content).

In the shown embodiment, the terminal member 620 has a total of three terminal members, that is, a first terminal member 620a, a second terminal member 620b, and a third terminal member 620c. The terminal members 620a, 620b, and 620c may be configured such that currents of different phases flow therethrough.

The number of terminal members 620 may be determined depending on the number of phase types of the current applied to the electric compressor 10.

The terminal members 620 are inserted through and coupled to the terminal coupling part 611 of the support member 610. In detail, the first terminal member 620a is inserted through and coupled to the first terminal coupling part 611a, the second terminal member 620b is inserted through and coupled to the second terminal coupling part 611b, and the third terminal member 620c is inserted through and coupled to the third terminal coupling part 611c.

The terminal member 620 includes the input terminal 621 and the output terminal 622.

The input terminal 621 is a part where the terminal member 620 is electrically conductively connected to the inverter 300. The input terminal 621 may be defined as one side of the terminal member 620 facing the inverter 300.

The input terminal 621 is inserted through and coupled to the input terminal insertion hole 312b formed in the inverter housing 310. Also, an end of the input terminal 621 is housed in the input terminal housing part 341 of the printed circuit board 340.

The input terminal 621 is electrically conductively connected to the input terminal housing part 341. In detail, the input terminal 621 is in electrically conductive contact with a conductive material provided to surround the outer circumference of the input terminal housing part 341.

Thus, the input terminal 621 may receive power and a control signal from the printed circuit board 340. The power and control signal received by the input terminal 621 is transferred to the output terminal 622 along the terminal member 620.

The input terminal 621 may have a total of three input terminals, that is, the first input terminal 621a, the second input terminal 621b, and the third input terminal 621c. The input terminals 621a, 621b, and 621c are configured such that currents of different phases flow therethrough. This is due to the application of a three-phase current to the electric compressor 10 according to an embodiment of the present disclosure.

An elastic member 640 may be provided in the input terminal 621. The elastic member 640 is located between the connection member 630 and an end of the input terminal 621 electrically conductively connected to the input terminal housing part 341.

The input terminal 621 may be inserted through and coupled to the elastic member 640. As will be described below, the elastic member 640 may be provided in the form of a coil spring having a hollow portion formed therein. The input terminal 621 may be inserted through and coupled to the hollow portion of the elastic member 640.

Through the configuration, vibration generated when the motor part 400 is operated may be damped by the elastic member 640. This will be described in detail below.

The output terminal 622 is a part where the terminal member 620 is electrically conductively connected to the motor part 400. The output terminal 622 may be defined as one side of the terminal member 620 facing the motor part 400. That is, the output terminal 622 is opposite to the above-described input terminal 621.

The output terminal 622 is inserted into and housed in the output terminal housing part 430 provided in the motor part 400.

The output terminal 622 is electrically conductively connected to the output terminal housing part 430. In detail, when the output terminal 622 is inserted into the output terminal housing part 430, the output terminal 622 and an electrically conductive member (not shown) provided in the output terminal housing part 430 are in electrically conductive contact with each other.

Thus, the output terminal 622 may receive power and a control signal applied to the input terminal 621 and transfer the power and control signal to the motor part 400.

The output terminal 622 may have a total of three output terminals, that is, the first output terminal 622a, the second output terminal 622b, and the third output terminal 622c. The output terminals 622a, 622b, and 622c are configured such that currents of different phases flow therethrough. This is due to the application of a three-phase current to the electric compressor 10 according to an embodiment of the present disclosure.

### (3) Description of Connection Member 630

The connection member 630 is configured to surround the terminal member 620 in order to prevent unintentional electrical conduction from occurring between the terminal member 620 and other members. Also, the connection member 630 may allow the terminal member 620 to stably remain inserted through and coupled to the terminal coupling part 611.

The connection member 630 is formed to extend lengthwise. The connection member 630 may have a cylindrical shape having a circular cross section.

The connection member 630 is configured to partially surround the terminal member 620. In detail, the connection member 630 is configured to surround parts spaced a predetermined distance from the input terminal 621 and the output terminal 622 included in the terminal member 620.

A hollow portion is formed inside the connection member 630. The terminal member 620 is inserted into and coupled to the hollow portion of the connection member 630. An inner circumferential surface of the connection member 630, that is, an outer circumferential surface of the hollow portion and an outer circumferential surface of the terminal member 620 may be brought in contact with each other.

The connection member 630 is inserted through and coupled to the terminal coupling part 611 of the support member 610. In other words, the connection member 630 is inserted through and coupled to the terminal coupling part 611 such that the outer circumferential surface of the connection member 630 is brought in contact with an inner circumferential surface of the terminal coupling part 611.

Accordingly, the terminal member 620 surrounded by the connection member 630 is inserted through and coupled to the terminal coupling part 611. Thus, it is possible to prevent the parts of the terminal member 620 other than the input terminal 621 and the output terminal 622 from being electrically conductive to an external member in an arbitrary manner.

The connection member 630 may be formed of an insulating material. In an embodiment, the connection member 630 may be formed of a ceramic material.

The terminal member 620 housed in the connection member 630 may be configured to be movable in the length direction. Alternatively, the connection member 630 inserted through and coupled to the terminal coupling part 611 may be configured to be moveable in the length direction.

Thus, when the elastic member 640 is compressed or stretched, the terminal member 620 may remain connected to the inverter 300 and the motor part 400 although the support member 610 moves toward the inverter 300 or the motor part 400.

### (4) Description of Elastic Member 640

The elastic member 640 is configured to damp vibration generated when the motor part 400 is driven such that the vibration is not transferred to the inverter 300.

The elastic member 640 may have any form capable of being compressed by the vibration of the motor part 400, storing a restoring force, returning to an original position, and canceling the vibration of the motor part 400. In an embodiment, the elastic member 640 may be provided as a coil spring.

In the shown embodiment, the terminal member 620 at the input terminal 621 side may be inserted into and coupled to the elastic member 640. Alternatively, the terminal member 620 at the output terminal 622 side may be inserted into and coupled to the elastic member 640.

Furthermore, the elastic member 640 has a plurality of elastic members, and the terminal members 620 at both of the input terminal 621 side and the output terminal 622 side may be inserted into each of the elastic members 640.

The elastic member 640 is located between the input terminal 621 and the connection member 630. This is for the connection member 630 to support one side of the elastic member 640 facing the support member 610 when the elastic member 640 is compressed by the vibration of the motor part 400.

To this end, it is preferable that the inner diameter of the elastic member 640, that is, the diameter of the hollow portion formed inside the elastic member 640 is smaller than the outer diameter of the connection member 630.

The elastic member 640 may be formed of any material and shape capable of storing a restoring force when the elastic member 640 is compressed or stretched. In an embodiment, the elastic member 640 may be formed of Fe-Ni 50% alloy (an iron alloy with 50% nickel content) or Cu-Ni 30% alloy (a copper alloy with 30% nickel content).

Also, the elastic member 640 may be formed of different materials along the length direction. In an embodiment, one side of the elastic member 640 facing the input terminal 621 may be formed of Cu-Ni 30% alloy, and one side of the elastic member 640 facing the support member 610 may be formed of Fe-Ni 50% alloy.

In another embodiment, one side of the elastic member 640 may be supported by the support member 610. In this case, the diameter of the hollow portion formed inside the elastic member 640 may be larger than the outer diameter of the connection member 630.

The elastic member 640 may have a plurality of elastic members. In the shown embodiment, since the terminal member 620 has a total of three terminal members, the elastic member 640 may have a total of three elastic members, that is, a first elastic member 640a, a second elastic member 640b, and a third elastic member 640c.

### 4. Description of Coupling Relationship between Inverter 300 and Motor Part 400 According to Embodiment of Present Invention

The coupling relationship in which the inverter 300 and the motor part 400 are electrically conductively connected to each other by the electrically conductive part 600 according to an embodiment of the present disclosure will be described in detail below with reference to FIGS. 7 and 9 to 11.

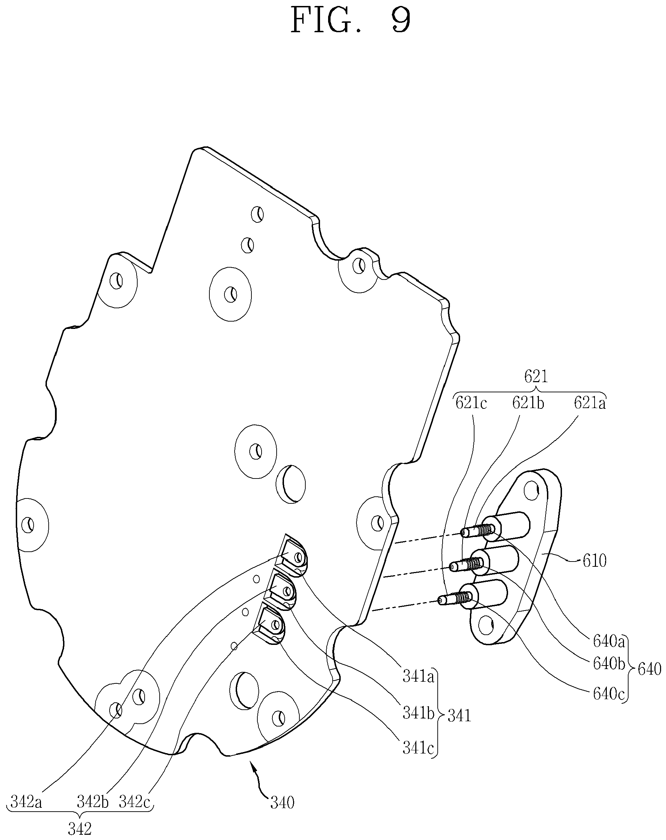

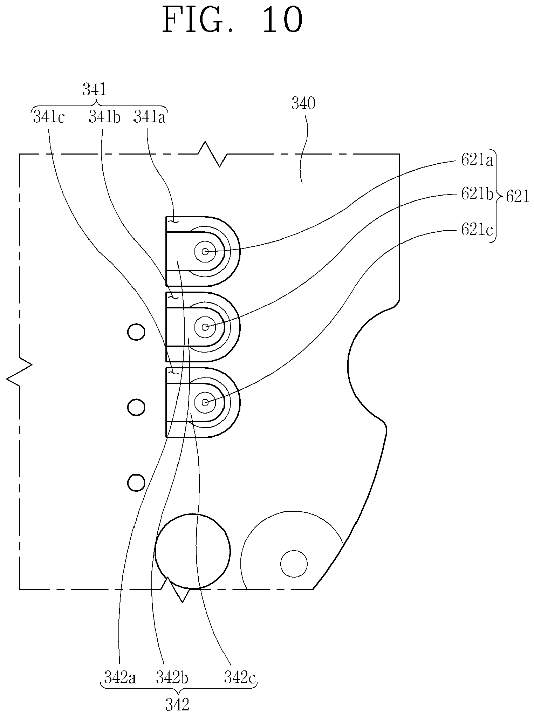

For the sake of understanding, the illustration of the inverter housing 310 is omitted in FIGS. 9 and 10.

### (1) Description of Connection Relationship between Inverter 300 and Electrically Conductive part 600

Referring to FIGS. 7, 9, and 10, the connection relationship between the inverter 300 and the electrically conductive part 600 is shown.

The inverter chamber S1 is formed between the inverter housing 310 and the inverter cover 320 of the inverter 300. The printed circuit board 340 and the inverter device 350 are housed in the inverter chamber S1.

Also, the inverter bracket 343 is provided on one side of the printed circuit board 340 facing the inverter housing 310. The printed circuit board 340 and the inverter device 350 may remain spaced a predetermined distance from the inverter housing 310 by using the inverter bracket 343.

The electrically conductive part 600 is coupled to the connector coupling part 312 of the inverter housing 310.

In detail, the support member 610 of the electrically conductive part 600 is inserted into and coupled to the support member insertion blind hole 312a of the connector coupling part 312. In an embodiment, the support member 610 may be fully inserted into the support member insertion blind hole 312a.

Also, the terminal member 620 of the electrically conductive part 600 is inserted into and coupled to the input terminal insertion hole 312b of the connector coupling part 312.

When the coupling between the electrically conductive part 600 and the inverter 300 is in progress, the input terminal 621 of the terminal member 620 inserted through and coupled to the input terminal insertion hole 312b is approaching the inverter 300.

When the approach is complete, the input terminal 621 is brought in contact with the input terminal connection part 342. The input terminal connection part 342 is formed of a conductive material and is electrically conductively connected to the printed circuit board 340 and an inverter device 350.

Accordingly, when the input terminal 621 is connected to the input terminal connection part 342, the input terminal 621 is electrically conductively connected to the printed circuit board 340 and the inverter device 350.

In this case, the elastic member 640 which the input terminal 621 is inserted through and coupled to is located between the inverter housing 310 and the support member 610. This will be described in detail below.

### (2) Description of Connection Relationship between Motor Part 400 and Electrically Conductive Part 600

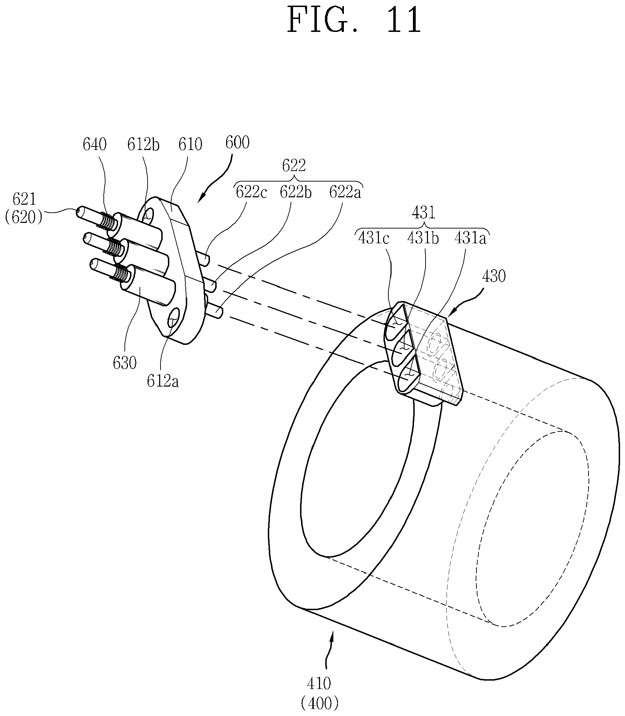

Referring to FIG. 11, the connection relationship between the motor part 400 and the electrically conductive part 600 is shown.

The output terminal housing part 430 is provided in the motor part 400. The electrically conductive part 600 is coupled to the output terminal housing part 430.

In detail, the output terminal 622 of the electrically conductive part 600 is inserted into and coupled to the output terminal housing part 430. In an embodiment, the output terminal 622 may be inserted into the output terminal housing part 430 until the end of the connection member 630 is brought into contact with the output terminal housing part 430.

An electrically conductive member (not shown) for electrically conductively connecting the stator 410 and the output terminal housing part 430 is provided in the output terminal housing part 430. The output terminal 622 housed in the output terminal housing part 430 is in electrically conductive contact with the electrically conductive member (not shown).

Thus, the output terminal 622 is electrically conductively connected to the electrically conductive member (not shown) and the stator 410. As a result, the power and control signal applied to the inverter 300 may be transferred to the stator 410 through the input terminal 621 and the output terminal 622.

Accordingly, the inverter 300 and the motor part 400 may be electrically conductively connected to each other just by the electrically conductive part 600 being inserted into and coupled to the inverter 300 and the motor part 400. Therefore, a complicated wiring structure for electrically conductively connecting the inverter and the motor part 400 is not required, and thus it is possible to simplify a wiring structure inside the electric compressor 10.

### 5. Description of Process of Damping Vibration of Motor Part 400 by Electrically Conductive Part 600 According to Embodiment of Present Invention

The electrically conductive part 600 according to an embodiment of the present disclosure includes an elastic member 640 for damping vibration generate due to the operation of the motor part 400.

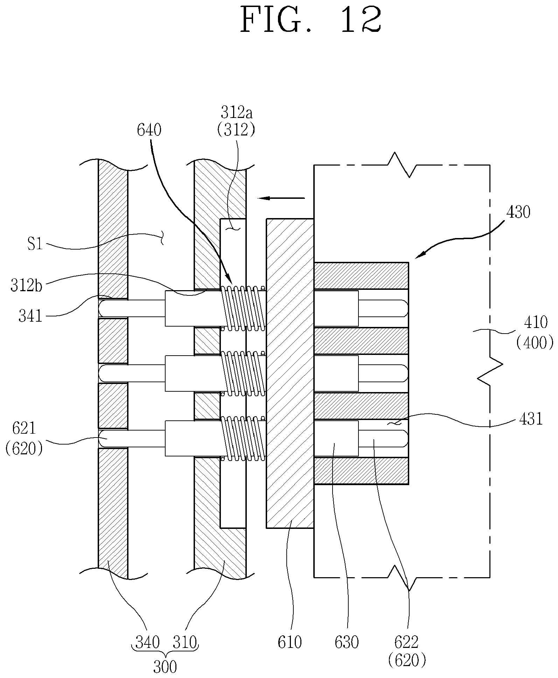

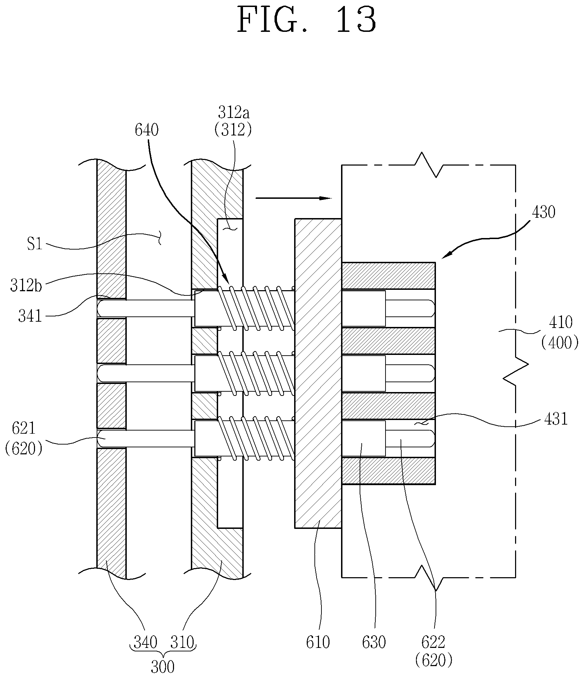

The process of damping vibration of the electric compressor 10 according to an embodiment of the present disclosure will be described in detail below with reference to FIGS. 12 and 13.

Referring to FIG. 12, it is shown that vibration is generated in a direction facing the inverter 300 when the motor part 400 is driven.

The inverter 300 and the motor part 400 are electrically conductively connected to each other by the electrically conductive part 600. Accordingly, along with the vibration of the motor part 400, the electrically conductive part 600 is also moved toward the inverter 300.

In this case, the elastic member 640 is provided between the support member 610 of the electrically conductive part 600 and the inverter housing 310 of the inverter 300. Accordingly, when the electrically conductive part 600 is moved by the vibration of the motor part 400, the elastic member 640 is compressed (see FIG. 12).

When the elastic member 640 is compressed, the vibration of the motor part 400 is damped. Accordingly, the vibration of the motor part 400 is not transferred to the inverter 300, and thus it is possible to prevent the printed circuit board 340 and the inverter device 350, which are sensitive to shock, from being damaged by the vibration.

The vibration of the motor part 400 may be generated in a direction opposite to the inverter 300 as well as in the direction facing the inverter 300.

When the inverter 300 is moved in the direction opposite to the inverter 300 along with the vibration of the motor part 400, the electrically conductive part 600 electrically conductively connected to the motor part 400 is also moved in the direction opposite to the inverter 300. In this case, the elastic member 640 is stretched along with the movement of the motor part 400 and the electrically conductive part 600.

When the elastic member 640 is stretched, the vibration of the motor part 400 is damped. Accordingly, the vibration of the motor part 400 is not transferred to the inverter 300, and thus it is possible to prevent the printed circuit board 340 and the inverter device 350, which are sensitive to shock, from being damaged by the vibration.

Furthermore, although the motor part 400 vibrates to cause displacement, the displacement is buffered by the elastic member 640, and thus the inverter 300 does not move. Thus, the inverter 300 may stably remain coupled to the main housing 100 and the motor part 400.

### 6. Description of Effects of Electric Compressor 10 Including Electrically Conductive Part 600 According to Embodiment of Present Invention

The electrically conductive part 600 includes the terminal member 620 formed of a conductive material. One side of the terminal member 620 facing the inverter 300 is defined as the input terminal 621, and the other side of the terminal member 620 facing the motor part 400 is defined as the output terminal 622. The input terminal 621 and the output terminal 622 are inserted into and coupled to the inverter 300 and the motor part 400. Thus, the inverter 300, the motor part 400, and the electrically conductive part 600 may be electrically conductively connected to each other.

Accordingly, it is not necessary to provide a separate wiring, and thus it is possible to simplify the structure for electrically conductively connecting the inverter 300 and the motor part 400. In particular, the input terminal 621 is fastened to the input terminal connection part 342 through a method such as soldering, and thus it is possible to stably maintain electrical conductive states between the inverter 300, the motor part 400, and the electrically conductive part 600.

Furthermore, there is no need for a process for connecting and fastening the wiring to the inverter 300 and the motor part 400. As a result, it is possible to simplify a process for producing the electric compressor 10.

Also, the elastic member 640 is provided on one side of the terminal member 620 facing the inverter 300, that is, one side adjacent to the input terminal 621. The elastic member 640 is compressed or stretched due to vibration generated during the operation of the motor part 400 and is configured to store a restoring force.

Accordingly, the vibration generated in the motor part 400 is damped by the elastic member 640 and thus is not transferred to the inverter 300. Thus, it is possible to prevent the inverter 300 from being damaged by the vibration generated by the motor part 400.

Furthermore, although the motor part 400 and the electrically conductive part 600 connected to the motor part 400 are moved due to the vibration of the motor part 400, the displacement is canceled by the elastic member. Thus, it is possible to prevent the damage of the inverter 300 that may be generated when the location of the inverter 300 is changed.

Also, the input terminal 621 of the electrically conductive part 600 is electrically conductively connected to the input terminal connection part 342 formed on the printed circuit board 340. Accordingly, it is not necessary to provide a separate busbar assembly for electrically conductively connecting the inverter 300 and the electrically conductive part 600.

Therefore, a space for housing the busbar assembly does not need to be formed inside the inverter 300, and thus it is possible to reduce the size of the inverter 300. Also, compared to the case in which the busbar assembly is provided, it is possible to improve the degree of freedom in placement of the printed circuit board 340 and the inverter device 350. Accordingly, the designing and producing process is simplified.

The foregoing description has been given of the preferred embodiments, but it will be apparent to those skilled in the art that various modifications and variations can be made in the present disclosure without departing from the scope of the disclosure as defined in the appended claims.

## Claims

1. A compressor comprising:
a compression part (500) to compress refrigerant;
a motor part (400) for driving the compression part (500);
an inverter (300) electrically connected to the motor part (400) to apply a control signal to the motor part (400); and
an electrically conductive part (600) configured to electrically connect the motor part (400) and the inverter (300), wherein the electrically conductive part (600) comprises:
a terminal member (620) formed in an elongated shape and having an input terminal (621) electrically connected to the inverter (300) and an output terminal (622) electrically connected to the motor part (400); and
an elastic member (640) provided between the inverter (300) and the motor part (400) for providing a restoring force when being compressed by vibration of the motor part (400);
wherein the input terminal (621) is slidably connected to the inverter (300) and/or the output terminal (622) is slidably connected to the motor part (400), while maintaining the electrical connection between the motor part (400) and the inverter (300).

2. The compressor according to claim 1, wherein the motor part (400) includes an output terminal housing part (430), in which the output terminal (622) is received, the output terminal housing part (430) being configured to maintain the electrical connection between the output terminal (622) and the motor part (400) during a sliding movement of the output terminal (622) in the output terminal housing part (430) caused by vibration of the motor part (400).

3. The compressor according to claim 1 or 2, wherein the inverter (300) includes an input terminal housing part (341), in which the input terminal (621) is received, the input terminal housing part (341) being configured to maintain the electrical connection between the input terminal (621) and the inverter (300) during a sliding movement of the input terminal (621) in the input terminal housing part (341) caused by vibration of the motor part (400).

4. The compressor according to claim 2 or 3, wherein the sliding movement of the input terminal (621) and/or the output terminal (622) corresponds to a deformation of the elastic member (640) due to vibration of the motor part (400).

5. The compressor according to any one of the preceding claims, wherein the terminal member (620) passes through the elastic member (640).

6. The compressor according to any one of the preceding claims, wherein the elastic member (640) has an elongated shape and comprises at least two parts sequentially arranged along a length direction thereof, and wherein the at least two parts are formed of at least two different materials.

7. The compressor according to any one of the preceding claims, wherein the elastic member (640) is fixed at one end to the inverter (300) and at the other end to the motor part (400), for providing a restoring force when being stretched.

8. The compressor according to any one of the preceding claims, wherein the inverter (300) comprises a printed circuit board (340), wherein the input terminal housing part (341) is formed through the printed circuit board (340); and
wherein the printed circuit board (340) comprises an input terminal connection part (342) provided at the input terminal housing part (341) and configured to be in electrical contact with the input terminal (621) to electrically connect the terminal member (620) to the printed circuit board (340) when the input terminal (621) is received into the input terminal housing part (341).

9. The compressor according to any one of the preceding claims, wherein the electrically conductive part (600) comprises at least two terminal members (620) and a support member (610) through which the at least two terminal members (620) pass.

10. The compressor according to claim 9, wherein the inverter (300) comprises an inverter housing (310) forming an external appearance of the inverter (300) on a side of the inverter (300) facing the motor part (400); and
wherein a support member insertion hole (312a) is formed as a recess in the side of the inverter housing (310) facing the motor part (400) and is configured to receive the support member (610).

11. The compressor according to claim 10, wherein the inverter housing (310) comprises an input terminal insertion hole (312b) formed in the support member insertion hole (312a) and wherein the input terminal (621) is inserted through the input terminal insertion hole (312b), such that the input terminal (621) is in electrical contact with the input terminal connection part (342).

12. The compressor according to any one of claims 9 to 11, wherein the support member (610) is fixed to the motor part (400) and the terminal members (620) slidably pass through the support member (610).

13. The compressor according to any one of claims 9 to 12, wherein the elastic member (640) has an elongated shape and comprises at least two parts sequentially arranged along a length direction thereof, wherein the at least two parts comprise:
a part formed at one end of the elastic member (640) adjacent to the support member (610) and formed of a copper-nickel (Cu-Ni) alloy material, and
another part formed at another end of the elongated elastic member (640) opposite to the one end and formed of an iron-nickel (Fe-Ni) alloy material.

14. The compressor according to any one of claims 9 to 13, wherein the electrically conductive part (600) comprises a connection member (630) inserted through the support member (610) and surrounding a part of the terminal member (620) in and/or adjacent to the support member (610), and wherein the connection member (630) is formed of an electrically insulating material.

15. The compressor according to any one of the preceding claims, wherein the terminal member (620) is formed of an iron-nickel alloy material.
